# EUROPEAN PATENT APPLICATION

(11) **EP 1 164 603 A2**
(43) Date of publication of application: **19.12.2001**
(21) Application number: 01114333.6
(22) Date of filing: 13.06.2001
(51) Int. Cl.: H01G 9/20

(54) **Dye sensitized solar cell**

(30) Priority: 15.06.2000 JP 2000180507; 15.08.2000 JP 2000246438
(71) Applicant: Fuji Photo Film Co., Ltd., Kanagawa-ken (JP)
(72) Inventor: Tsukahara, Jiro, Minami-Ashigara-shi, Kanagawa-ken (JP); Wariishi, Koji, Minami-Ashigara-shi, Kanagawa-ken (JP)
(74) Representative: Patentanwälte Dr. Solf & Zapf

(57) **Abstract**

A photoelectric conversion device comprising: a conductive support; a photosensitive layer containing a semiconductor fine particle on which a dye is adsorbed; a charge transfer layer; and a counter electrode, the dye being treated with a treatment solution composed of a quaternary salt and a solvent before or after the dye is adsorbed on the semiconductor fine particle.

## Description

### BACKGROUND OF THE INVENTION

The present invention relates to a photoelectric conversion device and a photoelectric cell using a dye-sensitized semiconductor fine particle, and particularly, to a photoelectric conversion device excellent in photoelectric conversion efficiency where the dye is treated with a quaternary salt and a photoelectric cell composed thereof.

Photoelectric conversion devices have been used for optical sensors, copying machines, photovoltaics, etc., and such as using a metal, a semiconductor, an organic pigment or dye, a combination thereof, etc. have been made practicable.

Photoelectric conversion devices using semiconductor fine particles sensitized by a dye (hereinafter referred to as "dye-sensitized photoelectric conversion device"), and materials and producing methods therefor have been disclosed in United States Patent Nos. 4,927,721, 4,684,537, 5,084,365, 5,350,644, 5,463,057, 5,525,440, WO 98/50393, Japanese Patent Laid-Open No. 7-249790 and Japanese Patent Publication No. 10-504521. The dye-sensitized photoelectric conversion devices can be produced at reduced costs because an inexpensive metal oxide semiconductor such as titanium dioxide can be used therefor without purification to a high purity. However, the conventional dye-sensitized photoelectric conversion devices do not necessarily have sufficiently high photoelectric conversion efficiency. It is thus highly desired to develop a dye-sensitized photoelectric conversion device exhibiting improved photoelectric conversion efficiency.

### OBJECT AND SUMMARY OF THE INVENTION

An object of the present invention is to provide a dye-sensitized photoelectric conversion device excellent in photoelectric conversion efficiency and a photoelectric cell composed thereof.

As a result of intense research in view of the above objects, the inventor has found that a dye-sensitized photoelectric conversion device using a dye treated with a particular solution is excellent in photoelectric conversion efficiency. The present invention has been accomplished by the finding.

Thus, a photoelectric conversion device of the present invention comprises: a conductive support; a photosensitive layer containing a semiconductor fine particle on which a dye is adsorbed; a charge transfer layer; and a counter electrode, wherein the dye being treated with a treatment solution composed of a quaternary salt and a solvent before or after the dye is adsorbed on the semiconductor fine particle.

A photoelectric cell of the present invention is composed of the photoelectric conversion device.

With respect to the photoelectric conversion device and the photoelectric cell of the present invention, the photoelectric conversion efficiency is further improved by satisfying any of the following conditions (1) to (9).
(1) The quaternary salt is preferably selected from the group consisting of tetralkylammonium salts, imidazolium salts and pyridinium salts.
(2) The quaternary salt preferably has a pyridyl group.
(3) The quaternary salt is particularly preferably represented by the following general formula (I): 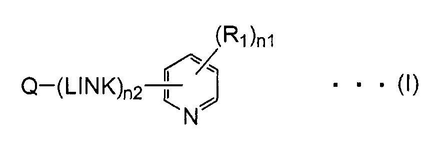 wherein *Q* represents a quaternary ammonium salt moiety, *LINK* represents a divalent linking group, *R*_{*1*} represents a substituent, *n1* represents an integer of 0 to 4, and *n2* represents 0 or 1.
(4) *Q* in the general formula (I) is preferably a tetralkylammonium salt moiety.
(5) The quaternary salt preferably has at least one alkyl group containing 6 or more carbon atoms.
(6) The solvent is preferably a nitrile compound.
(7) The dye preferably has an acidic group.
(8) The molecularity of the quaternary salt in the treatment solution is preferably equivalent to or more than the total number of the acidic group of the dye in the photosensitive layer.
(9) A ruthenium complex dye and/or a methine dye is particularly preferably used as the dye.

### BRIEF DESCRIPTION OF THE DRAWINGS

Fig. 1 is a partial cross sectional view showing a preferable structure of a photoelectric conversion device of the present invention;
Fig. 2 is a partial cross sectional view showing a preferable structure of a photoelectric conversion device of the present invention;
Fig. 3 is a partial cross sectional view showing a preferable structure of a photoelectric conversion device of the present invention;
Fig. 4 is a partial cross sectional view showing a preferable structure of a photoelectric conversion device of the present invention;
Fig. 5 is a partial cross sectional view showing a preferable structure of a photoelectric conversion device of the present invention;
Fig. 6 is a partial cross sectional view showing a preferable structure of a photoelectric conversion device of the present invention;
Fig. 7 is a partial cross sectional view showing a preferable structure of a photoelectric conversion device of the present invention;
Fig. 8 is a partial cross sectional view showing a preferable structure of a photoelectric conversion device of the present invention; and
Fig. 9 is a partial cross sectional view showing a preferable structure of a photoelectric conversion device of the present invention.

### DETAILED DESCRIPTION OF THE PREFERRED EMBODIMENTS

### [1] Photoelectric Conversion Device

A photoelectric conversion device of the present invention comprises: an electrically conductive layer; a photosensitive layer containing a semiconductor fine particle on which a dye is adsorbed; a charge transfer layer; and a counter electrode. The dye is treated with a treatment solution composed of a quaternary salt and a solvent before or after the dye is adsorbed on the semiconductor fine particle, to improve photoelectric conversion efficiency of the photoelectric conversion device.

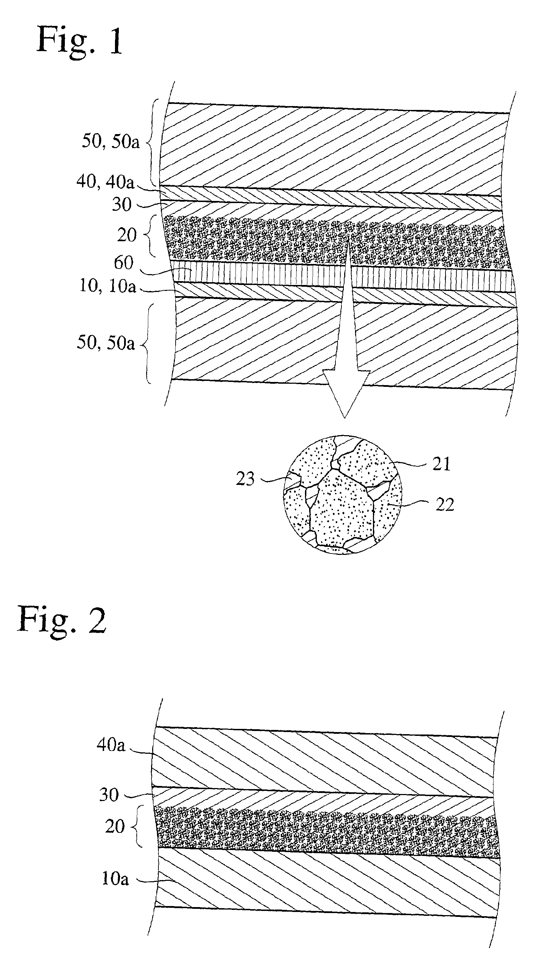

As shown in Fig. 1, the photoelectric conversion device of the present invention preferably comprises: an electrically conductive layer 10; a photosensitive layer 20 containing semiconductor fine particles 21 sensitized by dyes 22 and an charge-transporting material 23 penetrated into voids among the particles; a charge transfer layer 30; and a counter electrically conductive layer 40 laminated in this order. An undercoating layer 60 may be disposed between the electrically conductive layer 10 and the photosensitive layer 20. The charge-transporting material 23 is generally the same as the material used for the charge transfer layer 30. On the electrically conductive layer 10 and/or the counter electrically conductive layer 40 may be disposed a substrate 50 to improve the strength of the photoelectric conversion device. Hereinafter in the present invention, a layer composed of the electrically conductive layer 10 and the substrate 50 disposed thereon if necessary is referred to as "conductive support", and a layer composed of the counter electrically conductive layer 40 and the substrate 50 disposed thereon if necessary is referred to as "counter electrode". A photoelectric cell is constituted by connecting the photoelectric conversion device to an external circuit to electrically work or generate electricity in the external circuit. A photosensor is such a photoelectric conversion device as sensing optical information. Incidentally, the electrically conductive layer 10, the counter electrically conductive layer 40 and the substrate 50 shown in Fig. 1 may be a transparent electrically conductive layer 10a, a transparent counter electrically conductive layer 40a and a transparent substrate 50a, respectively.

In the photoelectric conversion device shown in Fig. 1, a light injected to the photosensitive layer 20 excites the dye 22, etc., excited high energy electrons therein are transported to a conduction band of the semiconductor fine particles 21, and they are diffused to reach to the electrically conductive layer 10. At this time, the dye 22 is in oxidized form. In the case of a photoelectric cell composed of the photoelectric conversion device, electrons in the electrically conductive layer 10 are returned to the oxidized dye through the counter electrically conductive layer 40 and the charge transfer layer 30 while working in the external circuit, so that the dye 22 is regenerated. In a boundary of each layer such as a boundary between the electrically conductive layer 10 and the photosensitive layer 20, a boundary between the photosensitive layer 20 and the charge transfer layer 30, a boundary between the charge transfer layer 30 and the counter electrically conductive layer 40, etc., components of each layer may be diffused and mixed.

A method for treating the dye with the treatment solution, and components and structures of the photoelectric conversion device of the present invention will be explained in detail below without intention of restricting the scope of the present invention.

### (A) Method for Treating Dye

The dye is treated with the treatment solution composed of the quaternary salt and the solvent. The treatment solution may be so-called dispersion. In the present invention, the term "the dye is treated with the treatment solution" means that the dye is made to come into contact with the treatment solution for a predetermined period. The predetermined period is not particularly limited, and generally 30 seconds to 24 hours. The dye may be treated with the treatment solution before or after the dye is adsorbed on the semiconductor fine particle, thus, the entire photosensitive layer may be treated with the treatment solution. Further, it does not matter whether the quaternary salt is adsorbed on the dye or not after the treatment. The quaternary salt may interact with the dye to provide an ion-exchanged product.

The treatment solution contains at least the quaternary salt and the solvent, and may contain other additives. The quaternary salt used in the present invention includes at least a nitrogen atom or a phosphorus atom, which has positive formal charge and is not directly connected to a hydrogen atom. Specific examples of the quaternary salt include quaternary ammonium salts, imidazolium salts, oxazolium salts, thiazolium salts, benzimidazolium salts, pyridinium salts, pyrazinium salts, quinolinium salts, quaternary phosphonium salts, etc. Among them, preferred are tetralkylammonium salts, imidazolium salts and pyridinium salts, more preferred are tetralkylammonium salts having a cyclic structure, imidazolium salts and pyridinium salts. The quaternary salt may include multivalent cationic moiety composed of 2 or more cationic groups connected to each other.

The quaternary salt preferably has at least one alkyl group containing 6 or more carbon atoms such as a hexyl group, an octyl group, a dodecyl group, etc. Such an alkyl group may have a substituent, examples thereof including halogen atoms, alkyl groups that may be a cycloalkyl group or a bicycloalkyl group, alkenyl groups that may be a cycloalkenyl group or a bicycloalkenyl group, alkynyl groups, aryl groups, heterocyclic groups, cyano group, hydroxyl group, nitro group, carboxyl group, alkoxy groups, aryloxy groups, silyloxy groups, heterocyclic oxy groups, acyloxy groups, carbamoyloxy groups, alkoxycarbonyloxy groups, aryloxycarbonyloxy groups, amino groups that may be anilino group, acylamino groups, aminocarbonylamino groups, alkoxycarbonylamino groups, aryloxycarbonylamino groups, sulfamoylamino groups, alkylsulfonylamino groups, arylsulfonylamino groups, mercapto groups, alkylthio groups, arylthio groups, heterocyclic thio groups, sulfamoyl groups, sulfo group, alkylsulfinyl groups, arylsulfinyl groups, alkylsulfonyl groups, arylsulfonyl groups, acyl groups, aryloxycarbonyl groups, alkoxycarbonyl groups, carbamoyl group, arylazo groups, heterocyclic azo groups, imide groups, phosphono group, phosphonyl group, phosphonyloxy group, phosphonylamino groups, silyl group, etc.

The quaternary salt may include organic or inorganic anion. Examples thereof include: halide ions such as a fluoride ion, a chloride ion, a bromide ion and iodide ion; perchlorate ion; tetrafluoroborate ion, hexafluorophosphate ion, acetate ion, trifluoroacetate ion, methanesulfonate ion, *p*-toluene sulfonate ion, trifluoromethane sulfonate ion, bis(trifluoromethane sulfonyl)imide ion, tris(trifluoromethane sulfonyl)methide ion, etc. The quaternary salt may be an inner salt.

The quaternary salt preferably has a pyridyl group. The pyridyl group may have a substituent with examples being the same as those of the above-mentioned substituent on the alkyl group containing 6 or more carbon atoms.

The quaternary salt having a pyridyl group is particularly preferably represented by the following general formula (I):

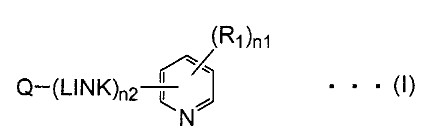

In the general formula (I), *Q* represents a quaternary ammonium salt moiety. The quaternary ammonium salt moiety may be a monovalent group generated by removing a hydrogen atom from a salt such as a tetralkylammonium salt, an imidazolium salt, an oxazolium salt, a thiazolium salt, a benzimidazolium salt, a pyridinium salt, a pyrazinium salt, a quinolinium salt, etc. The quaternary ammonium salt moiety is preferably a monovalent group generated from a tetralkylammonium salt (a tetralkylammonium salt moiety), particularly preferably a monovalent group generated from a tetralkylammonium salt having at least one alkyl group containing 6 or more carbon atoms such as a hexyl group, an octyl group, a dodecyl group, etc.

*Q* generally includes organic or inorganic anion. Examples of the anion include: halide ions such as a fluoride ion, a chloride ion, a bromide ion and iodide ion; a perchlorate ion; a tetrafluoroborate ion, a hexafluorophosphate ion, an acetate ion, trifluoroacetate ion, a methanesulfonate ion, a *p*-toluene sulfonate ion, a trifluoromethane sulfonate ion, bis(trifluoroethane sulfonyl)imide ion, tris(trifluoromethane sulfonyl)methide ion, etc. Among them, particularly preferred is iodide ion. *Q* may be an inner salt moiety.

In the general formula (I), *LINK* represents a divalent linking group. The divalent linking group may have a substituent with examples being the same as those of the above-mentioned substituent on the alkyl group containing 6 or more carbon atoms. Examples of the divalent linking group include: substituted or unsubstituted alkylene groups such as methylene group, ethylene group, propylene group and hexylene group; substituted or unsubstituted arylene groups such as phenylene group and naphtylene group; -O-; -S-; carbonyl group; substituted or unsubstituted imino groups such as imino group, methylimino group and phenylimino group; sulfonyl group; combinations thereof; etc. Of these groups, particularly preferred are alkylene groups.

In the general formula (I), *R*_{*1*} represents a substituent with examples being the same as those of the above-mentioned substituent on the alkyl group containing 6 or more carbon atoms. *R*_{*1*} is preferably an alkyl group such as methyl group, ethyl group, 2-propyl group, *t*-butyl group, hexyl group and dodecyl group.

In the general formula (I), *n1* represents an integer of 0 to 4, preferably represents an integer of 0 to 2. *n2* represents 0 or 1. Specific examples of the quaternary salt represented by the general formula (I) will be illustrated below without intention of restricting the scope of the present invention defined by the claims attached hereto.

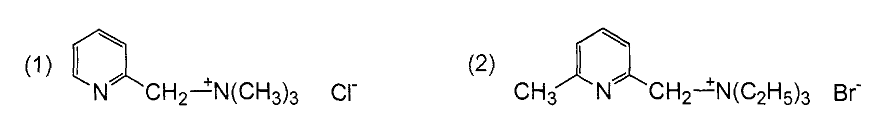

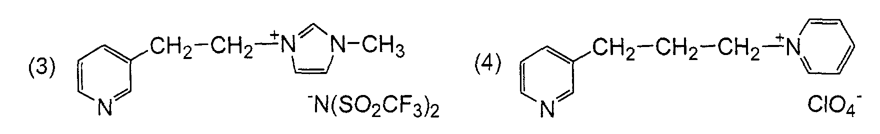

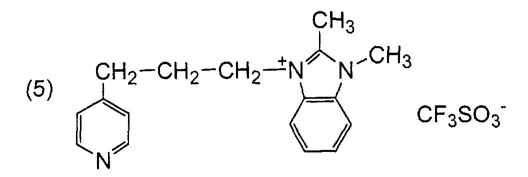

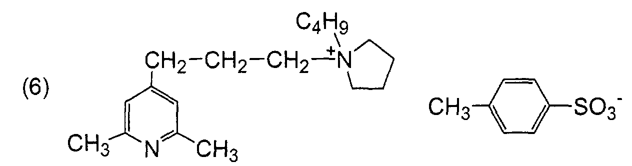

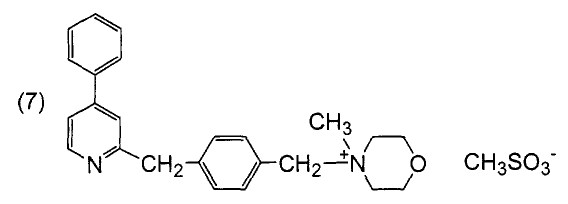

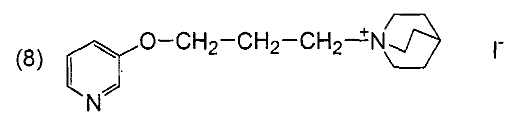

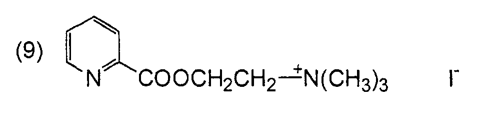

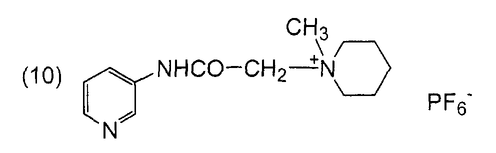

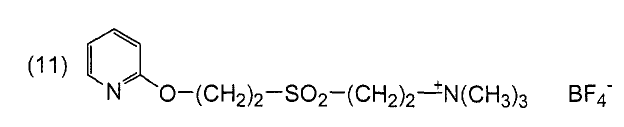

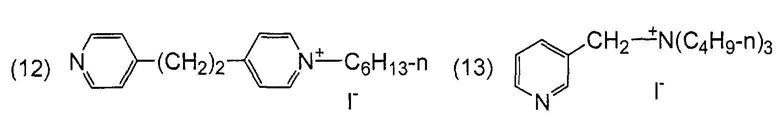

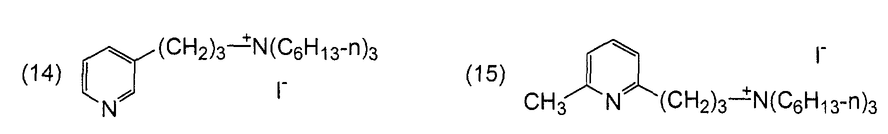

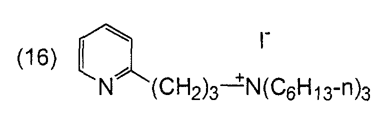

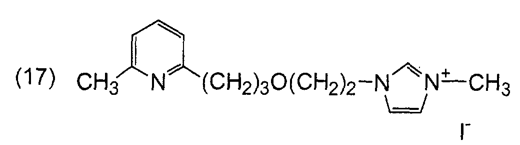

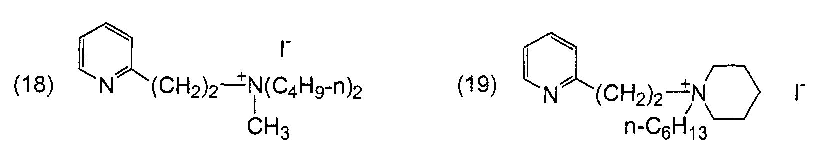

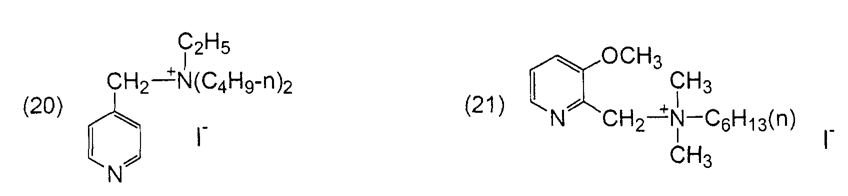

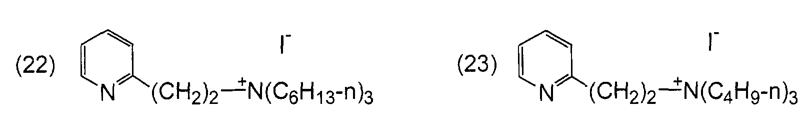

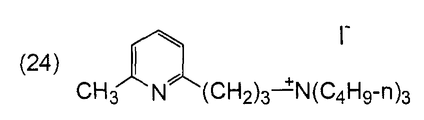

The quaternary salts shown below are also preferably used in the present invention.

(25) (CH₃)₄N⁺ Cl⁻

(26) (C₂H₅)₄N⁺ Br⁻

(27) (C₄H₉)₄N⁺ I⁻

(28) (C₆H₁₃)₄N⁺ I⁻

(29) (C₇H₁₅)₄N⁺ ClO₄⁻

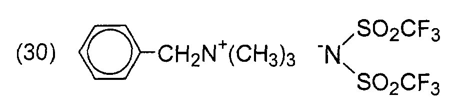

(31) n-C₁₆H₃₃N⁺(CH₃)₃ BF₄⁻

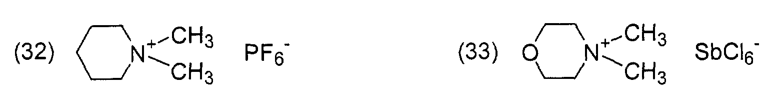

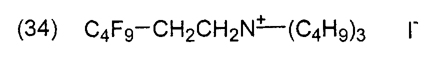

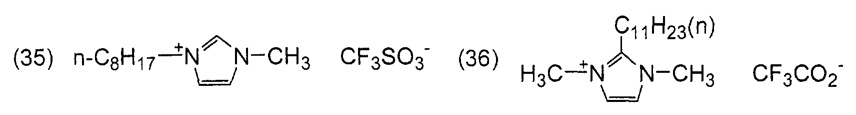

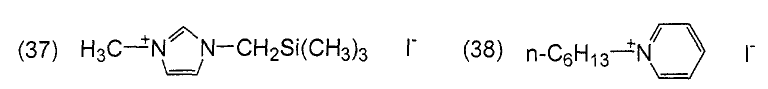

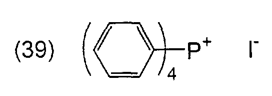

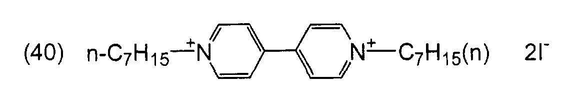

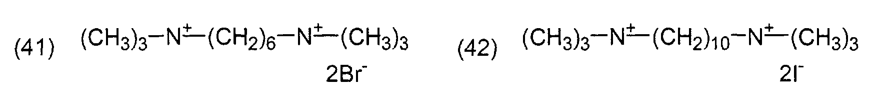

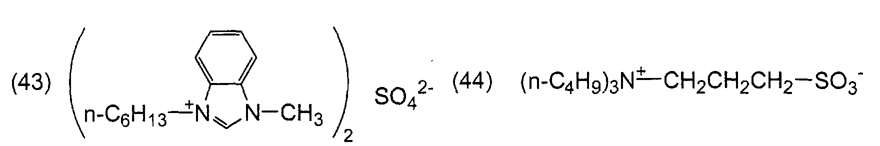

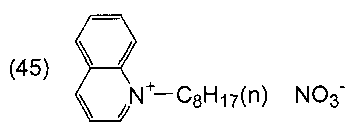

(46) (C₄F₉CH₂CH₂)₄-N⁺ I⁻

The solvent may be appropriately selected depending on the solubility of the quaternary salt. Examples of the solvent include: alcohols such as methanol, ethanol, *t*-butanol and benzyl alcohol; nitrile compounds such as acetonitrile, propionitrile and 3-methoxypropionitrile; nitromethane; halogenated hydrocarbons such as dichloromethane, dichloroethane, chloroform and chlorobenzene; ethers such as diethylether and tetrahydrofuran; dimethylsulfoxide; amides such as *N,N*-dimethylformamide and *N,N*-dimethylacetamide; *N*-methylpyrrolidone; 1,3-dimethylimidazolidinone; 3-methyloxazolidinone; esters such as ethyl acetate and butyl acetate; carbonates such as diethyl carbonate, ethylene carbonate and propylene carbonate; ketones such as acetone, 2-butanone and cyclohexanone; hydrocarbons such as hexane, petroleum ether, benzene and toluene; and mixtures thereof. Among them, the solvent is preferably a nitrile compound.

To the treatment solution containing the quaternary salt may be added an additive. Typical examples of the additive include carboxylated steroidal compounds such as chenodeoxycholic acid and cholic acid, ultraviolet-absorbing agents, surfactants, etc.

The concentration of the quaternary salt in the treatment solution is preferably 1 × 10⁻⁴ to 1 mol/l, more preferably 1 x 10⁻³ to 2 x 10⁻¹ mol/l. The molecularity of the quaternary salt in the treatment solution is equivalent to or more than the total number of acidic group, which will be described in detail below, of the dye in the photosensitive layer.

Although treated with the treatment solution may be the photosensitive layer or only the dye that is not yet adsorbed on the semiconductor fine particle, it is preferable that the photosensitive layer is treated with the treatment solution.

Method for treating the photosensitive layer with the treatment solution is not particularly limited if only it can efficiently make the treatment solution come into contact with the dye-adsorbed semiconductor fine particle. The method may be a soaking method, a coating method, a spraying method, etc. Of these, preferred is a soaking method. In the soaking method, temperature of the treatment solution and soaking period may be optionally controlled. In a typical embodiment, the photosensitive layer is soaked in the treatment solution at 20 to 80 °C for 30 seconds to 24 hours. After soaking, although the photosensitive layer may be immediately dried, it is preferable that the photosensitive layer is washed with a solvent. The solvent for washing the photosensitive layer is preferably such that same as the solvent for the treatment solution, or a polar solvent such as a nitrile compound, an alcohol, etc.

In the case where the dye is treated with the treatment solution before the dye is adsorbed on the semiconductor fine particle, for example, the dye may be dissolved in the treatment solution to isolate a salt composed of the dye and a cation moiety of the quaternary salt.

### (B) Photosensitive Layer

The photosensitive layer contains the semiconductor fine particle on which the dye is adsorbed. In the photosensitive layer, the semiconductor fine particle acts as a photosensitive substance to absorb a light and conduct charge separation, thereby generating electrons and positive holes. With respect to the dye-sensitized semiconductor fine particle, the light absorption and the generation of the electrons and the positive holes are primarily caused in the dye, and the semiconductor fine particle receives and conveys the electrons or the positive holes.

### (1) Semiconductor

Used as the semiconductor may be: an elementary substance semiconductor such as silicon and germanium; a III-V series compound semiconductor; a metal chalcogenide such as a metal oxide, a metal sulfide, a metal selenide and a composite thereof; a compound having a perovskite structure such as strontium titanate, calcium titanate, sodium titanate, barium titanate and potassium niobate; etc. An *n*-type semiconductor is preferably used in the present invention, in which conductor electrons act as a carrier under photo-excitation condition to provide anode current.

Preferable examples of the metal chalcogenide include: oxide of titanium, tin, zinc, iron, tungsten, zirconium, hafnium, strontium, indium, cerium, yttrium, lanthanum, vanadium, niobium or tantalum; sulfide of cadmium, zinc, lead, silver, antimony or bismuth; selenide of cadmium or lead; cadmium telluride; etc. Additionally, the other compound semiconductors such as phosphides of zinc, gallium, indium or cadmium, selenides of gallium-arsenic or copper-indium, copper-indium sulfide, etc. may be used in this invention. Further, composite semiconductors such as *M*_{*x*}*O*_{*y*}*S*_{*z*} and *M*_{*1x*}*M*_{*2y*}*O*_{*z*} are also preferably used in the present invention, wherein *M, M*_{*1*} and *M*_{*2*} independently represent a metal atom, *O* represents an oxygen atom, *S* represents a sulfur atom, and *x, y* and *z* represent numbers combined with each other to form a neutral molecule.

Preferable specific examples of the semiconductor include Si, TiO₂, SnO₂, Fe₂O₃, WO₃, ZnO, Nb₂O₅, CdS, ZnS, PbS, Bi₂S₃, CdSe, CdTe, SrTiO₃, GaP, InP, GaAs, CuInS₂ and CuInSe₂. Of these semiconductors, more preferred are TiO₂, SnO₂, Fe₂O₃, WO₃, ZnO, Nb₂O₅, CdS, PbS, CdSe, SrTiO₃, InP, GaAs, CuInS₂ and CuInSe₂, particularly preferred are TiO₂ and Nb₂O₅, and the most preferred is TiO₂. TiO₂ used in the present invention contains anatase-type crystal structure of preferably 70 volume % or more, particularly preferably 100 volume %. It is preferable that the semiconductor is doped with a divalent or trivalent metal, to increase electron conductivity thereof. Further, the semiconductor is preferably doped with a monovalent metal to prevent a reverse current from being provided from the semiconductor to the charge transfer layer.

The semiconductor may have a single crystal or poly crystal structure. The poly crystal semiconductor is preferred from the viewpoints of the production cost, the security of the raw materials, the energy-payback time, etc. The photosensitive layer is particularly preferably a porous semiconductor fine particle layer. The photosensitive layer may partly contain an amorphous semiconductor.

The particle size of the semiconductor fine particle is generally in the nm to µm level. The mean size of primary semiconductor particles, which is obtained from a diameter of a circle equivalent to a projected area thereof, is preferably 5 to 200 nm, more preferably 8 to 100 nm. Further, the mean size of secondary semiconductor particles in dispersion is preferably 0.01 to 30 µm.

Two or more of the semiconductor fine particles having a different particle size distribution may be mixed to use for the photosensitive layer. In this case, the average particle size of the smaller particles is preferably 25 nm or less, more preferably 10 nm or less. To improve a light-capturing rate of the photoelectric conversion device by scattering ray of incident light, the semiconductor fine particles having a large particle size, e.g. approximately 300 nm in diameter, may be used for the photosensitive layer.

Two or more kinds of the semiconductor fine particles may be used for the photosensitive layer. In this case, it is preferable that one is TiO₂, ZnO, Nb₂O₅ or SrTiO₃ and the other is SnO₂, Fe₂O₃ or WO₃. More preferred combination is ZnO and SnO₂, ZnO and WO₃, ZnO, SnO₂ and WO₃, etc. Each of the semiconductor fine particles may have a different diameter. Particularly preferred is a combination of TiO₂, ZnO, Nb₂O₅ or SrTiO₃ having a larger diameter and SnO₂, Fe₂O₃ or WO₃ having a smaller diameter. The larger diameter is preferably 100 nm or more, and the smaller diameter is preferably 15 nm or less.

Preferred as a method for producing the semiconductor fine particles are: sol-gel methods described in Sumio Sakka, "Zoru-Geru-Ho No Kagaku (Science of Sol-Gel Method)", Agune Shofusha (1998), Technical information Association, "Zoru-Geru-Ho Niyoru Hakumaku Coating Gijutu (Thin Film-Coating Technology by Sol-Gel Method)" (1995), etc.; and gel-sol methods described in Tadao Sugimoto, "Shin-Goseiho Geru-Zoru-Ho Niyoru Tanbunsanryusi No Gosei To Saizu-Keitaiseigyo (Synthesis of Mono-Dispersion Particles and Control of Their Size and Form by Novel Gel-Sol Method)", and MATERIA, Vol. 35, No. 9, Page 1012 to 1018 (1996). The method developed by Degussa Company, which comprises preparing oxides by subjecting chlorides to a high temperature hydrolysis in an oxyhydrogen salt, is also preferred.

In the case of using titanium oxide as the semiconductor fine particles, any of the above-described sol-gel methods, gel-sol methods and high temperature hydrolysis method are preferably used, further, a sulfuric acid method and a chlorine method described in Manabu Seino, "Sanka-Chitan Bussei To Ouyougijutu (Titanium oxide - Properties and Applied Technique)", Gihodo Shuppan, (1997) may be used. Of the sol-gel methods, also preferred are such that described in Christophe J. Barb'e, et al, Journal of American Ceramic Society, Vol. 80, No. 12, Page 3157 to 3171 (1997) and Burnside, et al, Chemistry of Materials, Vol. 10, No. 9, Page 2419 to 2425.

### (2) Semiconductor Fine Particle Layer

The semiconductor fine particles may be applied onto the conductive support by: a method where the conductive support is coated with a dispersion or a colloidal solution containing the particles; the above-mentioned sol-gel method; etc. A wet type film production method is relatively advantageous for the mass production of the photoelectric conversion device, improvement of properties of the semiconductor fine particle solution and the adaptability of the conductive support, etc. As such a wet type film production method, coating methods, printing methods, electrolytic deposition methods and electrodeposition techniques are typical examples. Further, the semiconductor fine particle layer may be disposed by: oxidizing a metal; an LPD method where a metal solution is subjected to ligand exchange, etc.; a sputtering method; a vapor deposition method; a CVD method; or an SPD method where a thermal decomposition-type metal oxide precursor is sprayed on a heated substrate to generate a metal oxide.

The dispersion containing the semiconductor fine particles may be prepared by: the sol-gel methods mentioned above; crushing the semiconductor in a mortar; dispersing the semiconductor while grinding it in a mill; synthesizing and precipitating the semiconductor fine particles in a solvent; etc.

As a dispersion solvent, water or organic solvents such as methanol, ethanol, isopropyl alcohol, citronellol, terpineol, dichloromethane, acetone, acetonitrile, ethyl acetate, etc. may be used. A polymer such as polyethylene glycol, hydroxyethylcellulose and carboxymethylcellulose, a surfactant, an acid, a chelating agent, etc. may be used as a dispersing agent, if necessary. In particular, it is preferable that polyethylene glycol is added to the dispersion because the viscosity of the dispersion and the porosity of the semiconductor fine particle layer can be controlled by changing the molecular weight of the polyethylene glycol, and the semiconductor fine particle layer containing polyethylene glycol is hardly peeled off.

Preferred coating methods include: a roller method and a dip method as an application series; an air-knife method and a blade method as a metering series; etc. Further, preferable as a method where an application and metering can be performed at the same time are a wire-bar method disclosed in JP-B-58-4589, a slide-hopper method described in United States Patent Nos. 2,681,294, 2,761,419, 2,761,791, etc., an extrusion method, a curtain method, etc. Furthermore, as for a wide use, a spin method and a spray method are preferred. As a wet type printing method, three major printing methods of a relief printing, an offset printing and a gravure printing, an intaglio printing, a gum printing, a screen printing, etc. are preferred. A preferable film production method may be selected from these methods in accordance with the viscosity of the dispersion and the desired wet thickness.

The semiconductor fine particle layer is not limited to a single layer. The dispersions each comprising the semiconductor fine particles having a different particle size may be subjected to a multi-layer coating. Further, the dispersions each containing different kinds of semiconductor fine particles, binder or additives may be subjected to a multi-layer coating. The multi-layer coating is also effectively used when the thickness of the layer is insufficient by coating of once.

Generally, when the thickness of the semiconductor fine particle layer, equal to the thickness of the photosensitive layer, becomes thicker, the amount of the dye incorporated therein per unit of the projected area increases, to make the light capturing rate higher. However, because diffusion distances of the generated electrons are increased in this case, loss owing to recombination of the electric charges is also increased. Consequently, the preferable thickness of the semiconductor fine particle layer is 0.1 to 100 µm. In the case of the photoelectric cell, the thickness of the semiconductor fine particle layer is preferably 1 to 30 µm, more preferably 2 to 25 µm. A coating amount of the semiconductor fine particles per 1 m² of the support is preferably 0.5 to 100 g, more preferably 3 to 50 g.

After coating the semiconductor fine particles on the conductive support, the particles are preferably subjected to a heat treatment, to electronically contact them with each other and to increase the coating strength and the adherence thereof with the support. The heating temperature is preferably 40 to 700 °C, more preferably 100 to 600 °C. The heating time is preferably 10 minutes to 10 hours. It is not preferred that the substrate having low melting point or softening point such as a polymer film is subjected to a high temperature treatment because such a substrate tends to be deteriorated thereby. The heat treatment is preferably carried out at a temperature as low as possible, for example, 50 to 350 °C, also from the viewpoint of cost. The semiconductor fine particle layer containing the smaller semiconductor fine particles having a size of 5 nm or less, a mineral acid, a metal oxide precursor, etc. can be heat-treated at such a low temperature. Further, the heat treatment may be carried out while applying ultraviolet ray, infrared ray, microwave, electric field, ultrasonic wave, etc. to the semiconductor fine particles, to reduce the heating temperature. To remove unnecessary organic compounds, the heat treatment is preferably carried out in combination with evacuation, oxygen plasma treatment, washing by pure water, a solvent or a gas, etc.

After the heat treatment, the semiconductor fine particle layer may be subjected to a chemical metal-plating using an titanium tetrachloride aqueous solution, etc. or an electrochemical metal-plating using an titanium trichloride aqueous solution, etc., to increase the surface area of the semiconductor fine particles, or to enhance a purity of the particles, thereby improving the electron-injecting efficiency into the particles from the dye. Further, to prevent a reverse current from being provided from the semiconductor fine particles to the charge transfer layer, on the semiconductor fine particles is preferably adsorbed an organic compound having low electron conductivity. The organic compound preferably has a hydrophobic group.

It is preferable that the semiconductor fine particle layer has a large surface area to adsorb lots of dyes. Therefore, the surface area of the semiconductor fine particle layer is preferably 10 times or more, more preferably 100 times or more of its projected area. The highest limit, even though it is not limited in particular, is generally a level of 1000 times.

### (3) Dye

The dye used for the photosensitive layer is not particularly limited if it can absorb a light in visible region, near infrared region, etc. and can sensitize the semiconductor fine particle. The dye is preferably selected from the group consisting of metal complex dyes, methine dyes, porphyrin dyes and phthalocyanine dyes, and particularly preferably a ruthenium complex dye and/or a methine dye. To make the photoelectric conversion wave range of the photoelectric conversion device larger, and to increase the photoelectric conversion efficiency, two or more kinds of the dyes are preferably used as a mixture or in combination thereof. In the case of using two or more kinds of the dyes, the kinds and the ratio of the dyes may be selected in accordance with the wave range and the strength distribution of the light source.

The dye preferably has an interlocking group, which can interact or adsorb to the surface of the semiconductor fine particles. Preferred interlocking groups include acidic groups such as -COOH, -OH, -SO₃H,-P(O)(OH)₂ and -OP(O)(OH)₂, and π-conductive chelating groups such as oxime group, dioxime group, hydroxyquinoline group, salicylate group and α-ketoenolate group. Among them, preferred are acidic groups, particularly preferred are -COOH, -P(O)(OH)₂ and -OP(O)(OH)₂. The interlocking group may form a salt with an alkaline metal, etc. or an intramolecular salt. In the polymethine dye, an acidic group such as squarylium ring group or croconium ring group formed by the methine chain may act as the interlocking group.

The preferred dyes used for the photosensitive layer will be specifically described below.

### (a) Metal Complex Dye

The metal complex dye used in the present invention is preferably a metallophthalocyanine dye, a metal porphyrin dye or a ruthenium complex dye, particularly preferably a ruthenium complex dye. The ruthenium complex dyes described in United States Patent Nos. 4,927,721, 4,684,537, 5,084,365, 5,350,644, 5,463,057 and 5,525,440, Japanese Patent Laid-Open Nos. 7-249790 and 2000-26487, Japanese Patent Publication No. 10-504512, WO 98/50393, etc. may be used in the present invention.

The ruthenium complex dye used in the present invention is preferably represented by the following general formula (II):

(A₁)ₚRu(B-a)(B-b)(B-c) (II)

In the general formula (II), *A*_{*1*} represents a monovalent or divalent ligand. *A*_{*1*} is preferably selected from the group consisting of Cl, SCN, H₂O, Br, I, CN, NCO, SeCN, β-diketone derivatives, oxalic acid derivatives and dithiocarbamic acid derivatives. *p* is an integer of 0 to 3. *B-a*, *B-b*, and *B-c* independently represent an organic ligand represented by any of the following formulae *B-1* to *B-10.*

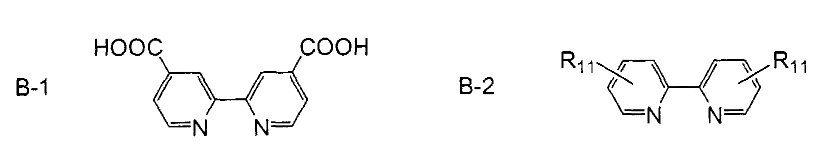

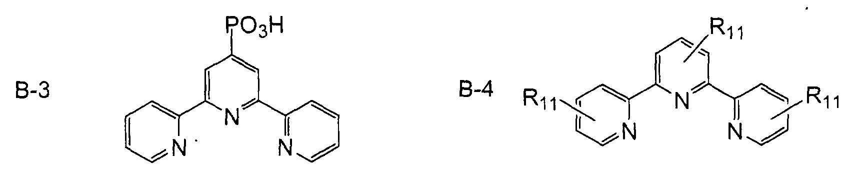

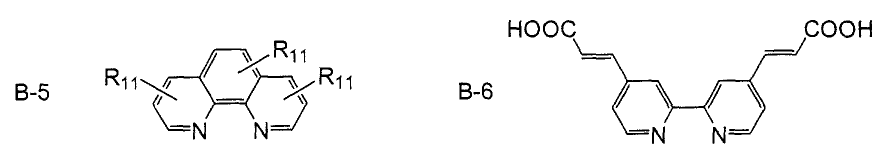

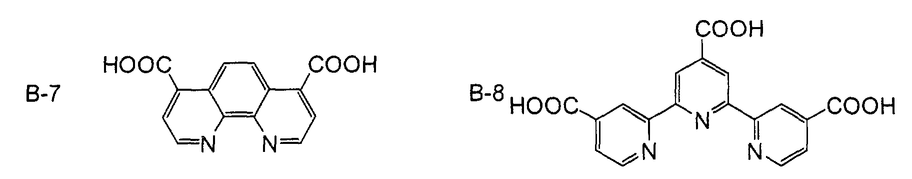

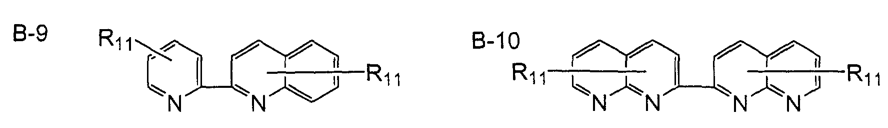

In the formulae *B-1* to *B-10*, *R*_{*11*} represents a hydrogen atom or a substituent. Specific examples of the substituent include: halogen atoms; substituted or unsubstituted alkyl groups having 1 to 12 carbon atom; substituted or unsubstituted aralkyl groups having 7 to 12 carbon atoms; substituted or unsubstituted aryl groups having 6 to 12 carbon atoms; acidic groups that may form a salt such as carboxyl group and phosphono group; etc. The alkyl group and the alkyl moiety of the aralkyl group may be straight or branched, and the aryl group and the aryl moiety of the aralkyl group may have a monocyclic structure or a polycyclic structure such as a condensed ring and a ring assemblage. *B-a*, *B-b* and *B-c* may be the same or different ligands, and the ruthenium complex dye represented by the general formula (II) may have only one or two of *B-a, B-b* and *B-c.*

The metal complex dyes preferably used in the present invention will be illustrated below without intention of restricting the scope of the present invention defined by the claims attached hereto.

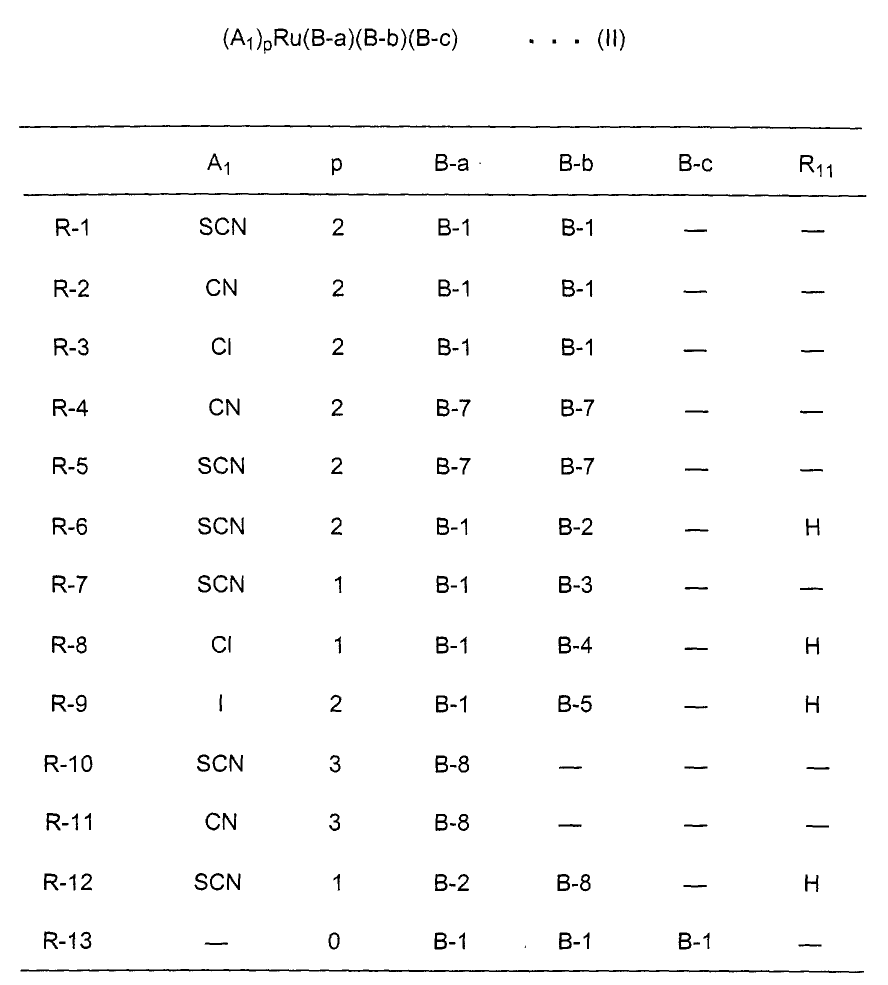

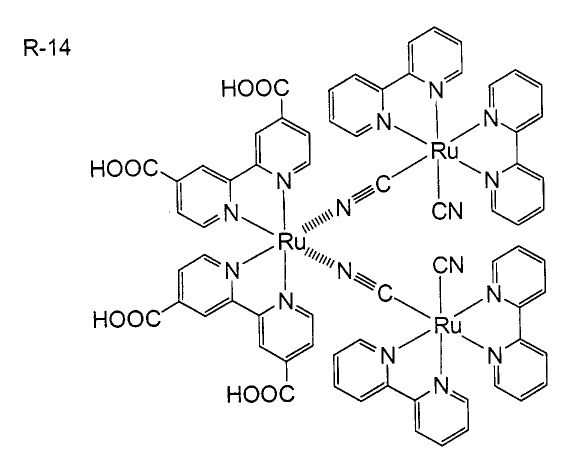

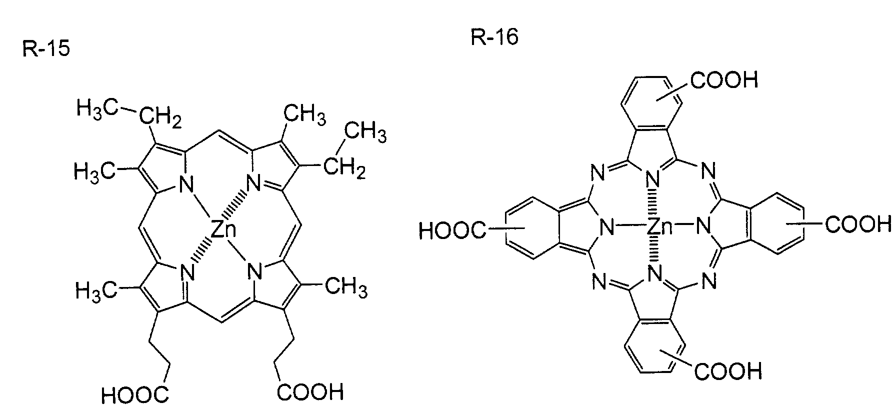

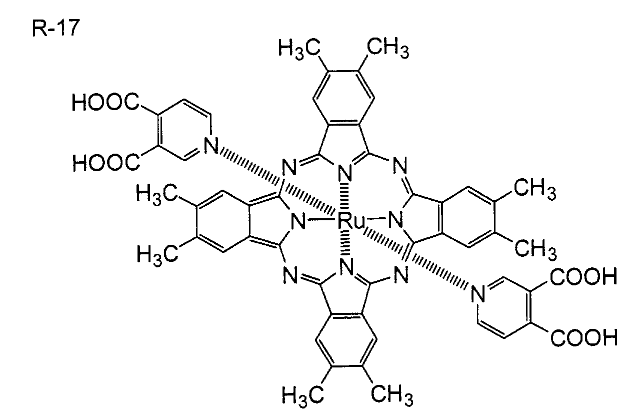

### (b) Methine Dye

The methine dye used in the present invention is preferably a polymethine dye such as a cyanine dye, a merocyanine dye, a squalilium dye, etc. The polymethine dyes disclosed in Japanese Patent Laid-Open Nos. 11-35836, 11-67285, 11-86916, 11-97725, 11-158395, 11-163378, 11-214730, 11-214731 and 11-238905, European Patent Nos. 892411 and 911841 are preferably used in the present invention. Specific examples of the methine dye are shown below.

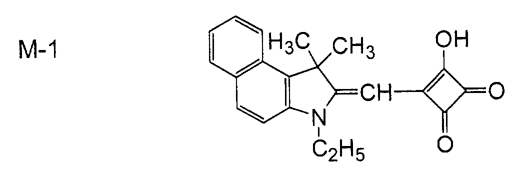

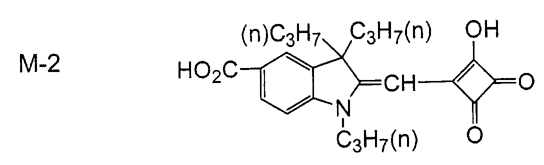

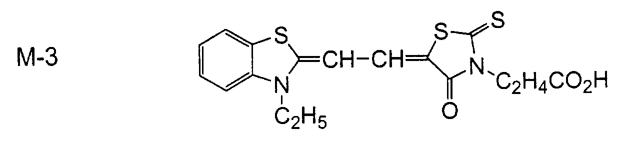

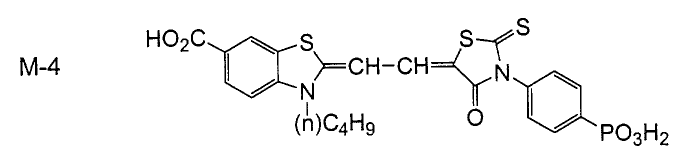

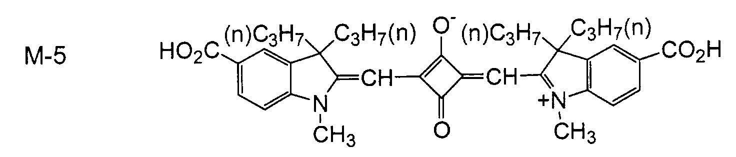

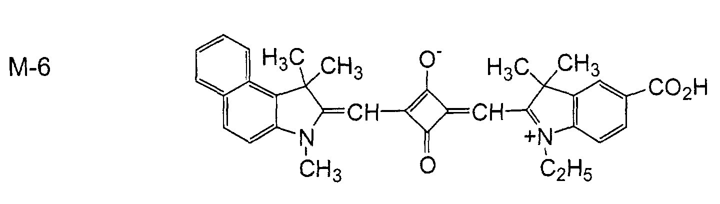

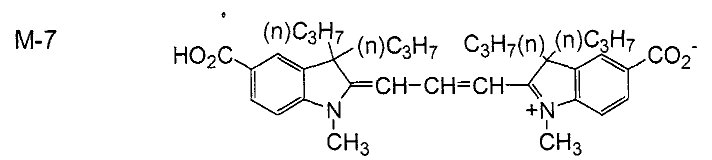

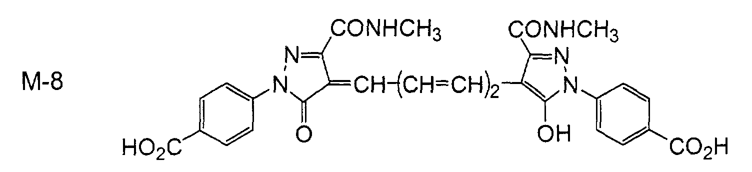

### (4) Adsorption of Dye to Semiconductor Fine Particle

The dye may be adsorbed to the semiconductor fine particles by soaking the conductive support having the well-dried semiconductor fine particle layer in a dye adsorption solution, or by applying the dye adsorption solution to the semiconductor fine particle layer. In the former case, a soaking method, a dipping method, a roller method, an air-knife method, etc. may be used. In the soaking method, the dye may be adsorbed at a room temperature or under reflux as described in Japanese Patent Laid-Open No. 7-249790. As an applying method of the latter case, a wire-bar method, a slide-hopper method, an extrusion method, a curtain method, a spin method, a spray method, etc. may be used.

Examples of a solvent for the dye adsorption solution include: alcohols such as methanol, ethanol, *t*-butanol and benzyl alcohol; nitrile compounds such as acetonitrile, propionitrile and 3-methoxypropionitrile; nitromethane; halogenated hydrocarbons such as dichloromethane, dichloroethane, chloroform and chlorobenzene; ethers such as diethylether and tetrahydrofuran; dimethylsulfoxide; amides such as *N,N*-dimethylformamide and *N,N*-dimethylacetamide; *N*-methylpyrrolidone; 1,3-dimethylimidazolidinone; 3-methyloxazolidinone; esters such as ethyl acetate and butyl acetate; carbonates such as diethyl carbonate, ethylene carbonate and propylene carbonate; ketones such as acetone, 2-butanone and cyclohexanone; hydrocarbons such as hexane, petroleum ether, benzene and toluene; and mixtures thereof.

The total amount of the dye is preferably 0.01 to 100 mmol per the unit surface area (1 m²) of the conductive support. The amount of the dye adsorbed on the semiconductor fine particles is preferably 0.01 to 1 mmol per 1 g of the semiconductor fine particles. Such an adsorption amount of the dye effects a sufficient sensitization to the semiconductors. Too small amount of the dye results in insufficient sensitization effect. On the other hand, if the amount of the dye is excessive, the dye unadsorbed on the semiconductor fine particles floats to reduce the sensitization effect.

To increase the adsorption amount of the dye, it is preferable that the semiconductor fine particle layer is subjected to a heat treatment before the dye is adsorbed thereon. After the heat treatment, it is preferable that the dye is quickly adsorbed on the semiconductor fine particle layer having a temperature of 60 to 150 °C before the layer is cooled to the room temperature, to prevent water from adsorbing onto the semiconductor fine particle layer.

To weaken an interaction between the dyes such as association, a colorless compound may be co-adsorbed onto the semiconductor fine particles together with the dye. The colorless compound preferably has surface activity, and examples thereof include steroid compounds having a carboxyl group such as chenodeoxycholic acid, and sulfonates shown below.

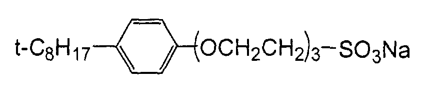

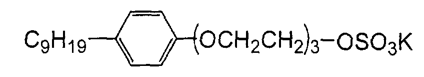

The dye unadsorbed on the semiconductor fine particle layer is preferably removed by washing immediately after the dye adsorption process. The washing is preferably carried out by a wet-type washing bath with a polar solvent such as acetonitrile or an organic solvent such as an alcohol solvent. The surface of the semiconductor fine particles may be treated with an amine compound or a quaternary salt after the dye adsorption process. The amine compound is preferably pyridine, 4-*t*-butylpyridine, polyvinylpyridine, etc., and the quaternary salt is preferably tetrabutylammonium iodide, tetrahexylammonium iodide, etc. The amine compound and the quaternary salt may be used singly when it is liquid, and may be used in a fashion of a solution in an organic solvent.

### (C) Conductive Support

The conductive support is composed of (1) a single layer of the electrically conductive layer, or (2) two layers of the electrically conductive layer and the substrate. In the case of (1), the electrically conductive layer is preferably made of a material that has a sufficient strength and can sufficiently seal the photoelectric conversion device, for example, a metal such as platinum, gold, silver, copper, zinc, titanium, aluminum and an alloy composed thereof. In the case of (2), the substrate on which the electrically conductive layer containing an electrically conductive material is disposed at the photosensitive layer side may be used as the conductive support. Preferable examples of the electrically conductive material include: metals such as platinum, gold, silver, copper, zinc, titanium, aluminum, indium and alloys composed thereof; carbon; electrically conductive metal oxides such as indium-tin composite oxides and tin oxides doped with fluorine; etc. The electrically conductive layer preferably has a thickness of 0.02 to 10 µm.

The surface resistance of the conductive support is preferably as low as possible. The surface resistance is preferably 50 Ω/square or less, more preferably 20 Ω/square or less.

When light is irradiated from the conductive support side, it is preferred that the conductive support is substantially transparent. Herein, the term "substantially transparent" means that the light transmittance is 10 % or more to a light in visible region to near infrared region (400 to 1200 nm). The light transmittance is preferably 50 % or more, more preferably 80 % or more. The conductive support particularly preferably has high light transmittance to a light which the photosensitive layer has sensitivity to.

The transparent conductive support is preferably constituted by disposing the transparent electrically conductive layer of an electrically conductive metal oxide on the transparent substrate of such material as a glass and a plastic by coating or vapor deposition. The transparent electrically conductive layer is preferably made of tin dioxide doped with fluorine or antimony, or indium-tin oxide (ITO). The transparent substrate may be made of a glass such as low-cost soda glass excellent in strength and non-alkali glass that is not affected by alkaline elution. Additionally, a transparent polymer film is preferably used as the transparent substrate. Used as the materials for the transparent polymer film may be tetracetylcellulose (TAC), polyethylene terephthalate (PET), polyethylene naphthalate (PEN), syndiotactic polystyrene (SPS), polyphenylenesulfide (PPS), polycarbonate (PC), polyarylate (PAr), polysulfone (PSF), polyestersulfone (PES), polyimide (PI), polyetherimide (PEI), cyclic polyolefin, brominated phenoxy, etc. To secure a sufficient transparency, the coating amount of the electrically conductive metal oxide is preferably 0.01 to 100 g per 1 m² of the glass or plastic substrate.

It is preferable that a metal lead is used to reduce the resistance of the transparent conductive support. The metal lead is preferably made of a metal such as platinum, gold, nickel, titanium, aluminum, copper, silver, etc. It is preferable that the metal lead is provided on the transparent substrate by a vapor deposition method, a sputtering method, etc., the transparent electrically conductive layer of conductive tin oxide or ITO being disposed thereon. The reduction in incident light quantity owing to the metal lead is suppressed to preferably 10 % or less, more preferably 1 to 5 %.

### (D) Charge Transfer Layer

The charge transfer layer replenishes electrons to the oxidized dye. The charge transfer layer may be composed of (i) an ion conductive electrolyte composition or (ii) a carrier-mediated, charge-transporting material utilizing charge transport mediated by a carrier in solid. Examples of (i) the ion conductive electrolyte composition include: molten salt electrolyte compositions containing a redox couple; electrolysis solutions where a redox couple is dissolved in a solvent; so-called gel electrolyte compositions where a solution including a redox couple is penetrated into a polymer matrix; solid electrolyte compositions; etc. Examples of (ii) the carrier-mediated, charge-transporting material include electron-transporting materials and hole-transporting materials. These materials may be used in combination with each other.

### (1) Molten Salt Electrolyte Composition

The molten salt electrolyte compositions are particularly preferably used for the charge transfer layer from the viewpoint of improving the durability and the photoelectric conversion efficiency of the photoelectric conversion device. The molten salt electrolyte composition comprises a molten salt electrolyte having a low melting point. In the present invention, pyridinium salts, imidazolium salts and triazolium salts disclosed in WO 95/18456, Japanese Patent Laid-Open No. 8-259543, "Denki Kagaku (Electrochemistry)", 65, 11, 923 (1997), etc. may be used as the molten salt electrolyte. The molten salt electrolyte preferably has the melting point of 100 °C or less, and it is particularly preferably liquid at the room temperature.

The molten salt electrolytes represented by any of the following general formulae *(Y-a)*, *(Y-b)* and *(Y-c)* can be preferably used in the present invention.

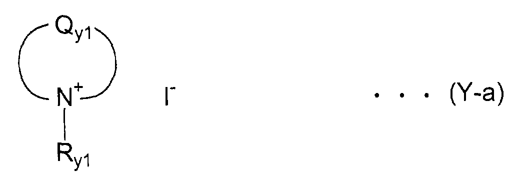

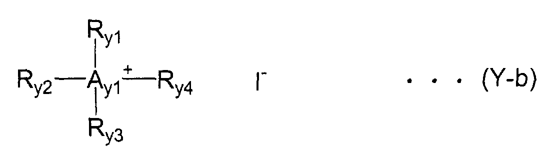

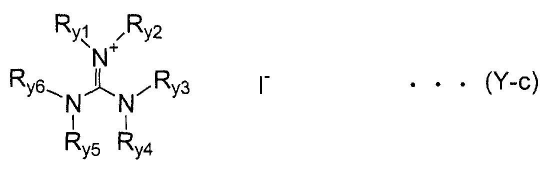

In the general formula *(Y-a), Q*_{*y1*} represents an atomic group forming an aromatic cation having a 5- or 6-membered ring structure with the nitrogen atom. *Q*_{*y1*} is preferably composed of atoms selected from the group consisting of carbon, hydrogen, nitrogen, oxygen and sulfur atoms. The 5-membered ring formed by *Q*_{*y1*} is preferably oxazole ring, thiazole ring, imidazole ring, pyrazole ring, iso-oxazole ring, thiadiazole ring, oxadiazole ring, triazole ring, indole ring or pyrrole ring, more preferably oxazole ring, thiazole ring or imidazole ring, particularly preferably oxazole ring or imidazole ring. The 6-membered ring formed by *Q*_{*y1*} is preferably pyridine ring, pyrimidine ring, pyridazine ring, pyrazine ring or triazine ring, more preferably pyridine ring.

In the general formula *(Y-b)*, *A*_{*y1*} represents a nitrogen atom or a phosphorus atom.

*R*_{*y1*} to *R*_{*y6*} in the general formulae *(Y-a), (Y-b)* and *(Y-c)* independently represent: a substituted or unsubstituted alkyl group preferably having 1 to 24 carbon atom, which may be straight, branched or cyclic, such as methyl group, ethyl group, propyl group, isopropyl group, pentyl group, hexyl group, octyl group, 2-ethylhexyl group, *t*-octyl group, decyl group, dodecyl group, tetradecyl group, 2-hexyldecyl group, octadecyl group, cyclohexyl group, cyclopentyl group, etc.; or a substituted or unsubstituted alkenyl group preferably having 2 to 24 carbon atoms, which may be straight or branched, such as vinyl group, allyl group, etc. *R*_{*y1*} to *R*_{*y6*} is more preferably an alkyl group having 2 to 18 carbon atoms or an alkenyl group having 2 to 18 carbon atoms, particularly preferably an alkyl group having 2 to 6 carbon atoms, respectively.

Two or more of *R*_{*y1*} to *R*_{*y4*} in the general formula *(Y-b)* may be bonded together to form a non-aromatic ring containing *A*_{*y1*}. Two or more of *R*_{*y1*} to *R*_{*y6*} in the general formula *(Y-c)* may be bonded together to form a ring.

*Q*_{*y1*} and *R*_{*y1*} to *R*_{*y6*} in the general formulae *(Y-a), (Y-b)* and *(Y-c)* may have a substituent, respectively. Preferable examples of the substituent include: halogen atoms such as F, Cl, Br and I; cyano group; alkoxy groups such as methoxy group, ethoxy group, methoxyethoxy group and methoxyethoxyethoxy group; aryloxy groups such as phenoxy group; alkylthio groups such as methylthio group and ethylthio group; alkoxycarbonyl groups such as ethoxycarbonyl group; carbonate groups such as ethoxycarbonyloxy group; acyl groups such as acetyl group, propionyl group and benzoyl group; sulfonyl groups such as methane sulfonyl group and benzene sulfonyl group; acyloxy groups such as acetoxy group and benzoyloxy group; sulfonyloxy groups such as methane sulfonyloxy group and toluene sulfonyloxy group; phosphonyl groups such as a diethylphosphonyl group; amido groups such as acetylamino group and benzoylamino group; carbamoyl groups such as *N,N*-dimethylcarbamoyl group; alkyl groups such as methyl group, ethyl group, propyl group, isopropyl group, cyclopropyl group, butyl group, 2-carboxyethyl group and benzyl group; aryl groups such as phenyl group and toluyl group; heterocyclic groups such as pyridyl group, imidazolyl group and furanyl group; alkenyl groups such as vinyl group and 1-propenyl group; silyl groups; silyloxy groups; etc.

The molten salt electrolytes represented by the general formula *(Y-a)*, *(Y-b)* or *(Y-c)* may form an oligomer (or a polymer) through *Q*_{*y1*} or *R*_{*y1*} to *R*_{*y6*}. The molten salt electrolytes may be used singly or in combination with each other. Further, I⁻ of the molten salt electrolytes represented by the general formula *(Y-a), (Y-b)* or *(Y-c)* may be replaced into the other anion. The other anion is preferably a halide ion such as Cl⁻ and Br⁻, SCN⁻, BF₄⁻, PF₆⁻, ClO₄⁻, N⁻(SO₂CF₃)₂, N⁻(SO₂CF₂CF₃)₂, CH₃SO₃⁻, CF₃SO₃⁻, CF₃COO⁻, BPh₄⁻, C⁻(SO₂CF₃)₃, etc., more preferably SCN⁻, BF₄⁻, N⁻(SO₂CF₃)₂, CF₃SO₃⁻ or CF₃COO⁻. Also, the molten salt electrolyte represented by the general formula *(Y-a)*, *(Y-b)* or *(Y-c)* may be used in combination with another iodine salt such as LiI or an alkali metal salt such as CF₃COOLi, CF₃COONa, LiSCN and NaSCN. Weight ratio of the alkali metal salt is preferably 0.02 to 2 weight %, more preferably 0.1 to 1 weight %, to 100 weight % of the molten salt electrolyte composition.

The molten salt electrolytes preferably used in the present invention will be illustrated below without intention of restricting the scope of the present invention defined by the claims attached hereto.

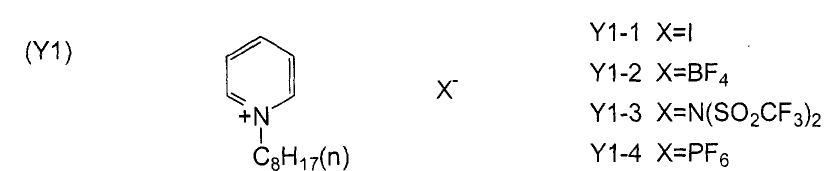

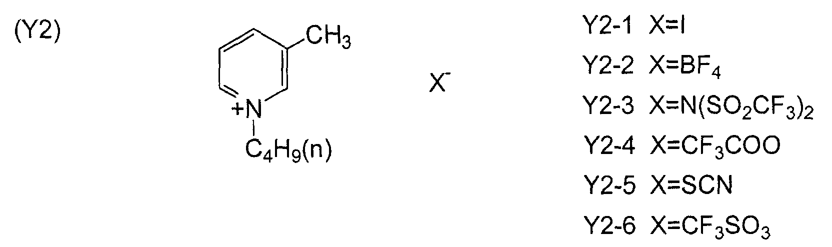

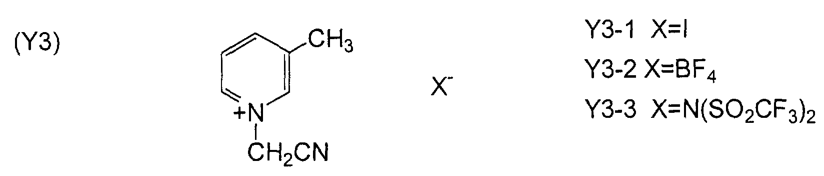

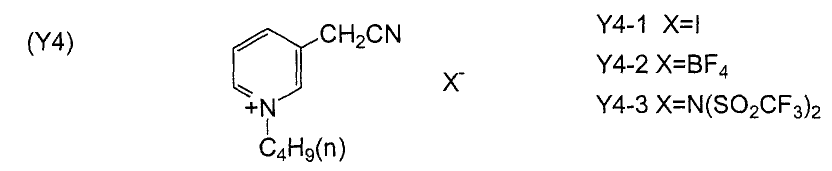

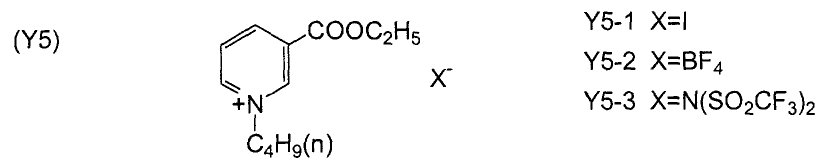

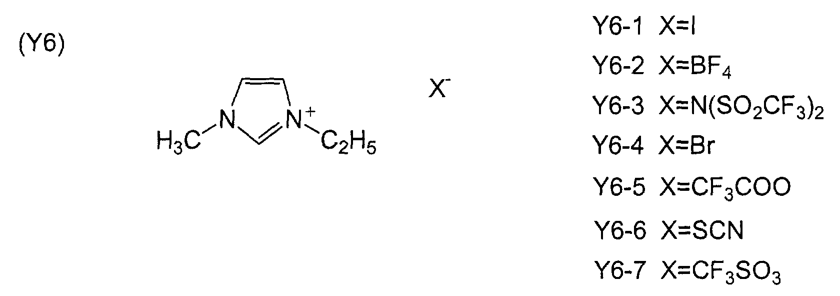

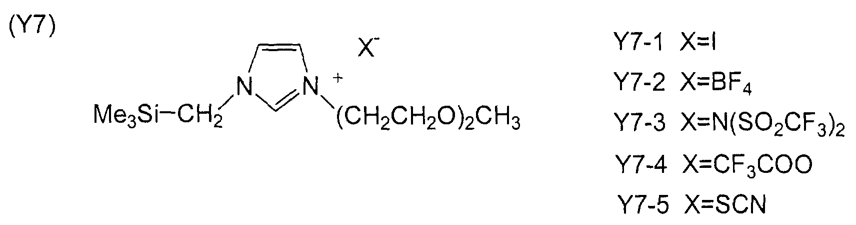

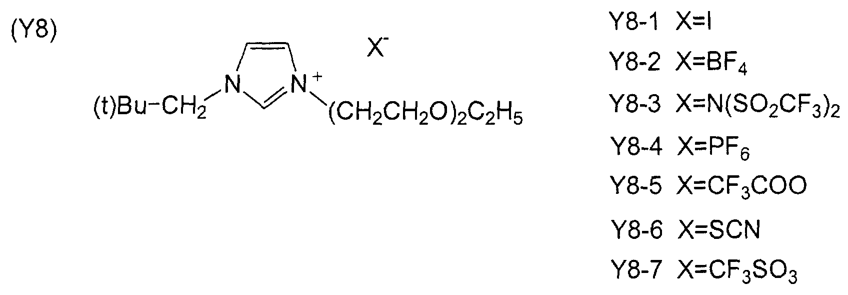

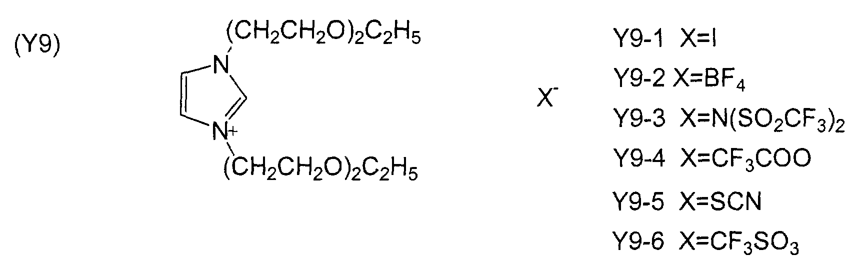

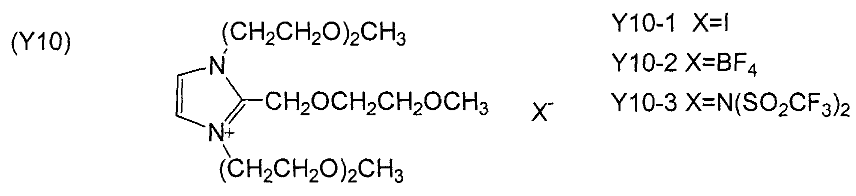

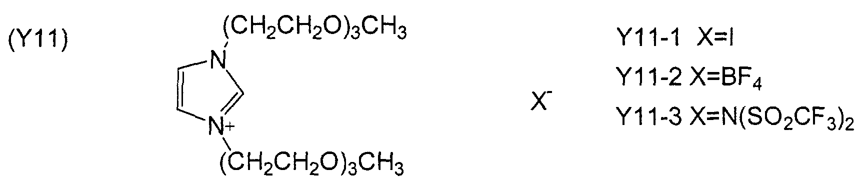

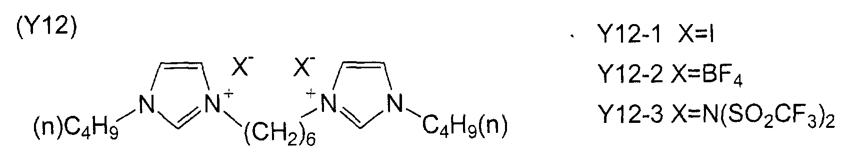

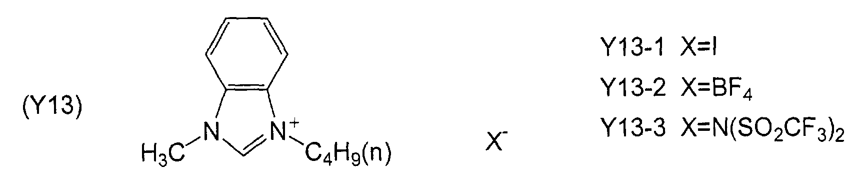

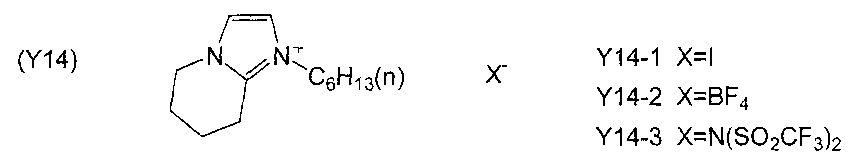

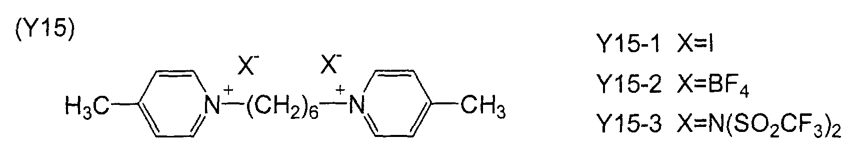

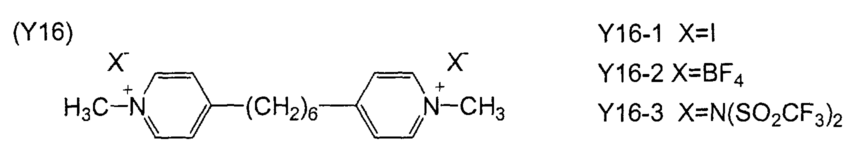

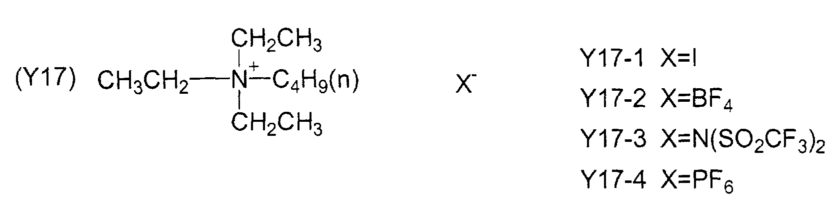

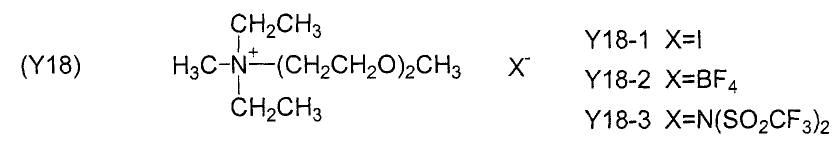

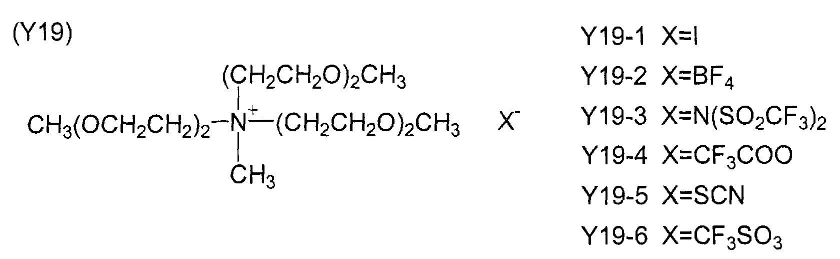

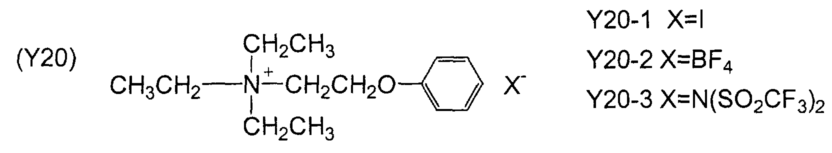

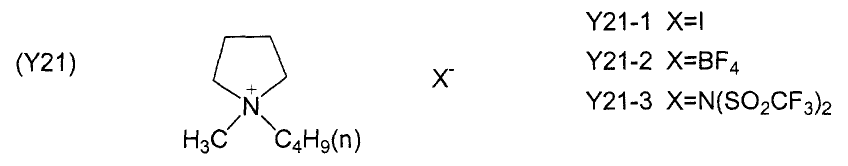

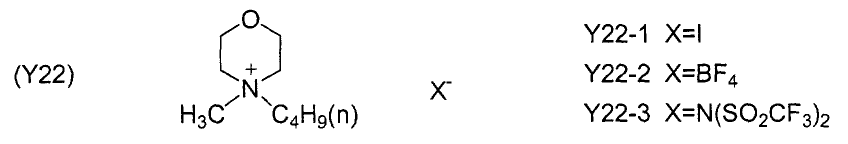

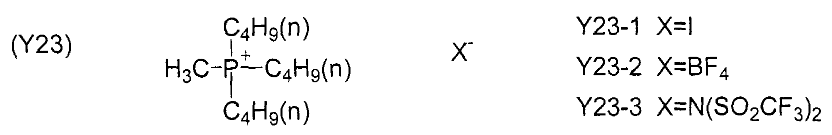

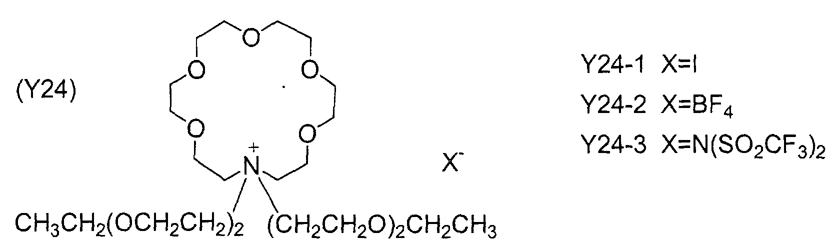

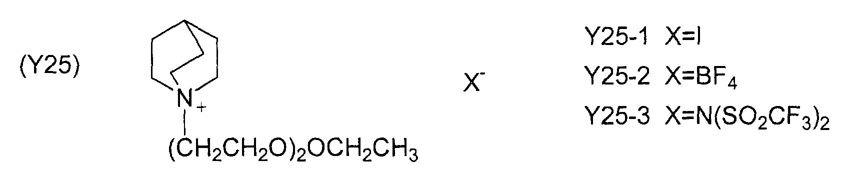

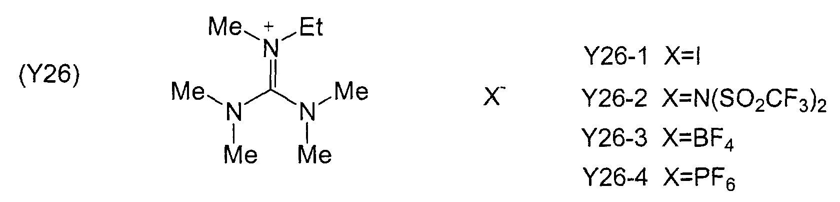

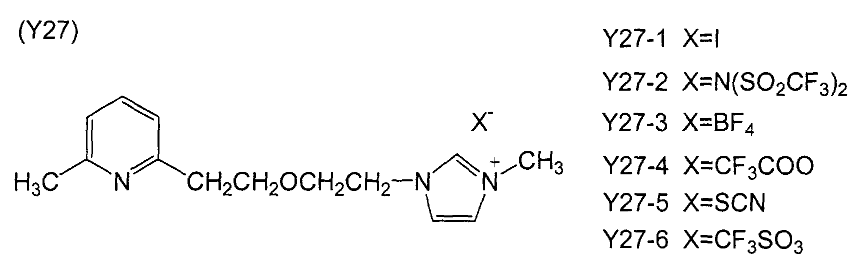

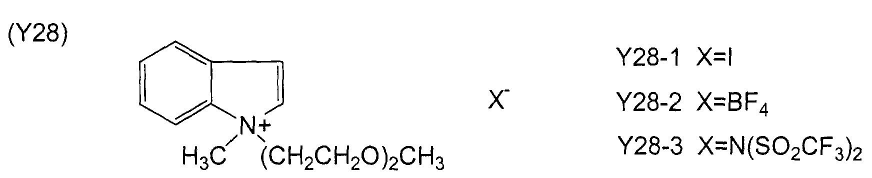

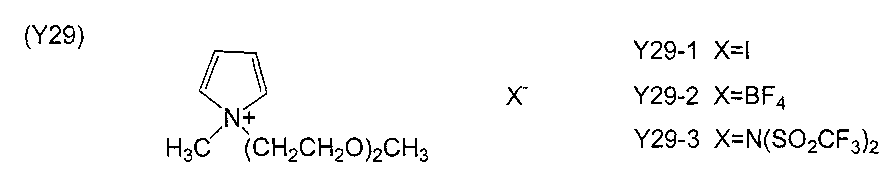

Though the molten salt electrolyte composition may comprise a solvent described below, it particularly preferably comprises no solvent. The content of the molten salt electrolyte is preferably 50 weight % or more, particularly preferably 90 weight % or more, based on the entire composition. The weight ratio of the iodine salts contained in the molten salt electrolyte composition is preferably 50 weight % or more to the entire salts contained therein.

The molten salt electrolyte composition preferably comprises iodine. The iodine-content is preferably 0.1 to 20 weight %, more preferably 0.5 to 5 weight % based on the entire composition.

### (2) Electrolysis Solution

The electrolysis solution used in the present invention is preferably composed of an electrolyte, a solvent and an additive. The electrolyte may be: a combination of I₂ and an iodide (a metal iodide such as LiI, NaI, KI, CsI and CaI₂, a quaternary ammonium iodide such as a tetralkylammonium iodide, pyridinium iodide and imidazolium iodide, etc.); a combination of Br₂ and a bromide (a metal bromide such as LiBr, NaBr, KBr, CsBr and CaBr₂, a quaternary ammonium bromide such as a tetralkylammonium bromide and pyridinium bromide, etc.); a metal complex such as a ferrocyanide-ferricyanide and a ferrocene-ferricinium ion; a sulfur compound such as sodium polysulfide and alkylthiol-alkyldisulfide; a viologen dye; hydroquinone-quinone; etc. Among them, preferred is a combination of I₂ and LiI or the quaternary ammonium iodide. A plurality of the electrolytes may be mixed to be in use.

The concentration of the electrolyte in the electrolysis solution is preferably 0.1 to 10 M, more preferably 0.2 to 4 M. Further, the electrolysis solution may comprise iodine, and the concentration of iodine therein is preferably 0.01 to 0.5 M.

The solvent used for the electrolysis solution is preferably such that has a low viscosity and a high ionic mobility, or that has a high permittivity and can increase the actual carrier concentration of the electrolysis solution, to exhibit an excellent ionic conductibility. Examples of the solvent include: carbonates such as ethylene carbonate and propylene carbonate; heterocyclic compounds such as 3-methyl-2-oxazolidinone; ethers such as dioxan and diethyl ether; chain ethers such as ethyleneglycol dialkylethers, propyleneglycol dialkylethers, polyethyleneglycol dialkylethers and polypropyleneglycol dialkylethers; alcohols such as methanol, ethanol, ethyleneglycol monoalkylethers, propyleneglycol monoalkylethers, polyethyleneglycol monoalkylethers and polypropyleneglycol monoalkylethers; glycols such as ethylene glycol, propylene glycol, polyethylene glycol, polypropylene glycol and glycerin; nitrile compounds such as acetonitrile, glutarodinitrile, methoxyacetonitrile, propionitrile and benzonitrile; aprotic polar solvents such as dimethylsulfoxide (DMSO) and sulfolane; water; etc. These solvents may be used in combination with each other.

Further, to the above-mentioned molten salt electrolyte composition and the electrolysis solution is preferably added a basic compound such as t-butylpyridine, 2-picoline, 2,6-lutidine, etc., as described in J. Am. Ceram. Soc., 80 (12), 3157 to 3171 (1997). The concentration of the basic compound therein is preferably 0.05 to 2 M.

### (3) Gel Electrolyte Composition

The molten salt electrolyte composition and the electrolysis solution mentioned above may be gelled (solidified) to prepare the gel electrolyte composition. Gelation may be achieved by: adding a polymer; adding an oil-gelling agent; polymerization of monomers including a multifunctional monomer; a cross-linking reaction of a polymer; etc.

In the case where the gel electrolyte composition is prepared by adding a polymer, compounds described in "Polymer Electrolyte Reviews 1 and 2", edited by J. R. MacCallum and C. A. Vincent, ELSEIVER APPLIED SCIENCE may be used as the polymer. Of the compounds, polyacrylonitrile and poly(vinylidene fluoride) are preferred.

In the case where the gel electrolyte composition is prepared by adding an oil-gelling agent, compounds described in J. Chem. Soc. Japan, Ind. Chem. Soc., 46, 779 (1943), J. Am. Chem. Soc., 111, 5542 (1989), J. Chem. Soc., Chem. Commun., 390 (1993), Angew. Chem. Int. Ed. Engl., 35, 1949 (1996), Chem. Lett., 885 (1996), J. Chem. Soc., Chem. Commun., 545 (1997), etc. may be used as the oil-gelling agent. Of the compounds, preferred are those having an amide structure.

In the case where the gel electrolyte composition is prepared by a cross-linking reaction of a polymer, it is preferable that a polymer containing a group having cross-linking reactivity is used in combination with a cross-linking agent. The group having the cross-linking reactivity is preferably amino group or a nitrogen-containing heterocyclic group such as pyridyl group, imidazolyl group, thiazolyl group, oxazolyl group, triazolyl group, morpholyl group, piperidyl group, piperazyl group, etc. The cross-linking agent is preferably an electrophilic agent having a plurality of functional group that can be attacked by the nitrogen atom, for example, multi-functional alkyl halides, aralkyl halides, sulfonates, acid anhydrides, acyl chlorides, isocyanates, α,β-unsaturated sulfonyl compounds, α,β-unsaturated carbonyl compounds, α,β-unsaturated nitrile compounds, etc. Cross-linking methods disclosed in Japanese Patent Laid-Open Nos. 2000-17076 and 2000-86724 may be used in the present invention.

Further, a method for gelling an electrolysis solution disclosed in Japanese Patent Laid-Open No. 11-185863 and a method for gelling a molten salt electrolyte composition disclosed in Japanese Patent Laid-Open No. 2000-58140 may be used in this invention.

### (4) Hole-Transporting Material

In the present invention, an organic solid hole-transporting material, an inorganic solid hole-transporting material or a combination thereof may be used for the charge transfer layer instead of the ion conductive electrolyte composition such as the molten salt electrolyte composition.

### (a) Organic Hole-Transporting Material

Preferred examples of the organic hole-transporting material used in this invention include: aromatic amines disclosed in J. Hagen, et al., Synthetic Metal, 89, 215 to 220 (1997), Nature, Vol. 395, 8 Oct. 1998, Page 583 to 585, WO 97/10617, United States Patent Nos. 4,923,774 and 4,764,625, Japanese Patent Laid-Open Nos. 59-194393, 5-234681, 4-308688, 3-269084, 4-129271, 4-175395, 4-264189, 4-290851, 4-364153, 5-25473, 5-239455, 5-320634, 6-1972, 7-138562, 7-252474 and 11-144773, etc.; triphenylenes disclosed in Japanese Patent Laid-Open Nos. 11-149821, 11-148067 and 11-176489, etc.; oligothiophene compounds disclosed in Adv. Mater., 9, No. 7, 557, 1997, Angew. Chem. Int. Ed. Engl., 34, 3, 303 to 307, 1995, J. Am. Chem. Soc., Vol. 120, No. 4, Page 664 to 672, 1998, etc.; and conductive polymers such as polypyrrole disclosed in K. Murakoshi, et al., Chem. Lett., 471, 1997 and polyacetylene, poly(*p*-phenylene), poly(*p*-phenylenevinylene), polythienylenevinylene, polythiophene, polyaniline, polytoluidine and derivatives thereof disclosed in "Handbook of Organic Conductive Molecules and Polymers", Vol. 1 to 4, edited by NALWA, published by WILEY.

As described in Nature, Vol. 395, 8 Oct. 583 to 585 (1998), to the organic hole-transporting material may be added a compound having cation radical such as tris(4-bromophenyl)aminium hexachloroantimonate to control the dopant level, or a salt such as Li[(CF₃SO₂)₂N] to achieve potential-control of surface of the semiconductor, thereby compensating a space-charge layer.

### (b) Inorganic Hole-Transporting Material

The inorganic hole-transporting material may be a *p*-type inorganic compound semiconductor. Band gap of the *p*-type inorganic compound semiconductor is preferably 2 eV or more, more preferably 2.5 eV or more. Ionization potential of the *p*-type inorganic compound semiconductor should be smaller than that of the photosensitive layer to reduce holes of the dye. Although the ionization potential of the *p*-type inorganic compound semiconductor may be selected depending on the kind of the dye, generally, it is preferably 4.5 to 5.5 eV, more preferably 4.7 to 5.3 eV. The *p*-type inorganic compound semiconductor is preferably a compound having a monovalent copper such as CuI, CuSCN, CuInSe₂, Cu(In,Ga)Se₂, CuGaSe₂, Cu₂O, CuS, CuGaS₂, CuInS₂, CuAlSe₂, etc. Among them, CuI and CuSCN are preferred, and CuI is the most preferred. GaP, NiO, CoO, FeO, Bi₂O₃, MoO₂, Cr₂O₃, etc. are also used as the *p*-type inorganic compound semiconductor.

### (5) Method for Forming Charge Transfer Layer

The charge transfer layer may be provided by any of the following two methods. One is a method where the counter electrode is stuck on the photosensitive layer beforehand and the material for the charge transfer layer in the liquid state is made to penetrate a gap therebetween. Another is a method where the charge transfer layer is directly disposed on the photosensitive layer, the counter electrode being then disposed thereon.

In the former method, the material for the charge transfer layer may be made to penetrate the gap by a normal pressure process utilizing capillarity, or by a reduced pressure process where the material is pumped up from the gap to replace gas phase therein with liquid phase.

In the case of providing a wet charge transfer layer by the latter method, the wet charge transfer layer is applied to the photosensitive layer, the counter electrode is disposed on the wet charge transfer layer without drying it, and edges thereof is subjected to a treatment for preventing liquid-leakage, if necessary. In the case of providing a gel charge transfer layer by the latter method, the charge transfer material may be applied in the liquid state and gelled by polymerization, etc. In this case, the counter electrode may be disposed on the charge transfer layer before or after drying and fixing the charge transfer layer.

The charge transfer layer composed of the electrolysis solution, the wet organic hole-transporting material, the gel electrolyte composition, etc. may be disposed by a soaking method, a roller method, a dip method, an air-knife method, an extrusion method, a slide-hopper method, a wire-bar method, a spin method, a spray method, a cast method, various printing methods, etc. similarly to the case of forming the semiconductor fine particle layer, or adsorbing a dye to the semiconductor mentioned above.

The charge transfer layer composed of the solid electrolyte, the solid hole transporting material, etc. may be formed by a dry film-forming method such as a vacuum deposition method and a CVD method, and followed by disposing the counter electrode thereon. The organic hole-transporting material may be made to penetrate into the photosensitive layer by a vacuum deposition method, a cast method, a coating method, a spin-coating method, a soaking method, an electrolytic polymerization method, a photo-polymerization method, etc. The inorganic hole-transporting material may be made to penetrate into the photosensitive layer by a cast method, a coating method, a spin-coating method, a soaking method, an electrolytic deposition method, an electroless deposition method, etc.

### (E) Counter Electrode

The counter electrode is the counter electrically conductive layer, which is supported by the substrate, if necessary. Examples of the electrically conductive material used for the counter electrically conductive layer include: metals such as platinum, gold, silver, copper, aluminum, magnesium, rhodium and indium; carbon; and electrically conductive metal oxides such as indium-tin composite oxides and fluorine-doped tin oxides. Among them, preferred are platinum, gold, silver, copper, aluminum and magnesium. The substrate of the counter electrode is preferably made of a glass or a plastic, to be coated or vapor-deposited with the electrically conductive material. The counter electrically conductive layer preferably has a thickness of 3 nm to 10 µm, although the thickness is not particularly limited. The surface resistance of the counter electrically conductive layer is desirably as low as possible. The surface resistance is preferably 50 Ω/square or less, more preferably 20 Ω/square or less.

Light may be irradiated from any one or both side of the conductive support and the counter electrode, so that at least one of them must be substantially transparent to have light reached to the photosensitive layer. From a viewpoint of improving electric generation efficiency, it is preferable that the conductive support is transparent to irradiate light therethrough. In this case, the counter electrode preferably has a light-reflective property. Such a counter electrode may be composed of a glass or a plastic having a vapor-deposited layer of metal or electrically conductive oxide, or metal thin film.

The counter electrode may be disposed by applying, metal-plating, or vapor-depositing (PVD, CVD, etc.) the electrically conductive material directly on the charge transfer layer. Alternatively, the counter electrode composed of the substrate and the counter electrically conductive layer may be disposed by sticking the counter electrically conductive layer side surface thereof on the charge transfer layer. Further, the counter electrode may be disposed on the photosensitive layer through a spacer before forming the charge transfer layer. It is preferable that the metal lead is used to reduce the resistance of the counter electrode, as is similar to the conductive support. The metal lead is particularly preferably used for the transparent counter electrode. Preferable embodiments of the metal lead used for the counter electrode are the same as those of the metal lead used for the conductive support mentioned above.

### (F) Others

It is preferable that a fine semiconductor thin film is provided between the conductive support and the photosensitive layer as an undercoating layer to prevent short-circuit of the counter electrode and the conductive support, particularly in the case of the charge transfer layer composed of the electron-transporting material or the hole-transporting material. The undercoating layer is preferably made of TiO₂, SnO₂, Fe₂O₃, WO₃, ZnO or Nb₂O₅, more preferably made of TiO₂. The undercoating layer may be disposed by a spray-pyrolysis method described in Electrochim. Acta, 40, 643 to 652 (1995), a sputtering method, etc. The thickness of the undercoating layer is preferably 5 to 1000 nm, more preferably 10 to 500 nm.

Functional layers such as a protective layer and a reflection-preventing layer may be disposed on any one or both of the conductive support and the counter electrode. The functional layers may be disposed by a method selected in accordance with the materials therefor, such as a coating method, a vapor-deposition method and a sticking method.

### (G) Interior Structure of Photoelectric Conversion Device

As described above, the photoelectric conversion device may have various interior structures in accordance with an end of use. The structures are classified into two major forms, a structure allowing light incidence from both faces, and a structure allowing it from only one face. Each of Figs. 2 to 9 illustrates an example of the interior structure of the photoelectric conversion device, which is preferable in the present invention.

As for the structure illustrated in Fig. 2, the photosensitive layer 20 and the charge transfer layer 30 are disposed between the transparent electrically conductive layer 10a and the transparent counter electrically conductive layer 40a. This structure allows light incidence from both faces of the device.

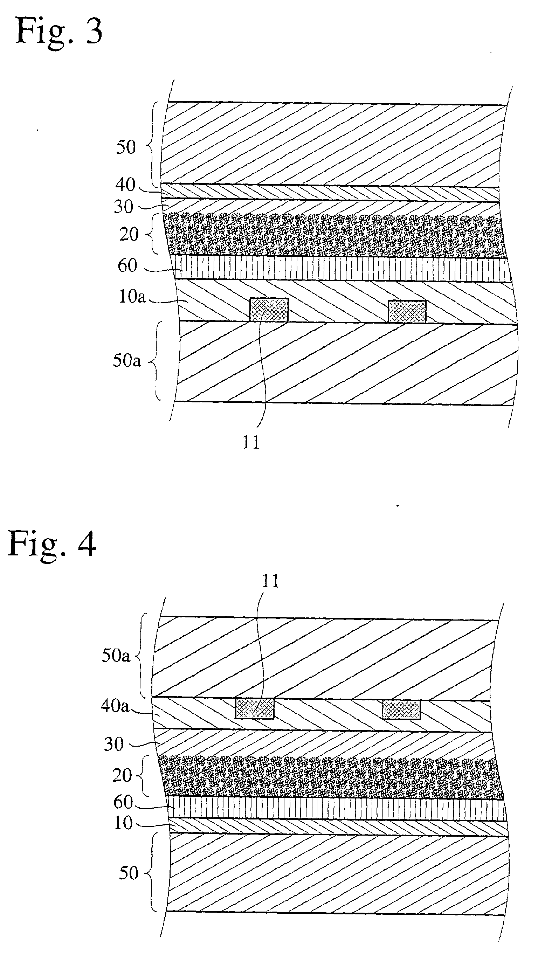

As for the structure illustrated in Fig. 3, on the transparent substrate 50a partially having the metal lead 11 is disposed the transparent electrically conductive layer 10a, the undercoating layer 60, the photosensitive layer 20, the charge transfer layer 30 and the counter electrically conductive layer 40 are laminated in this order, and the substrate 50 is further placed thereon. This structure allows light incidence from the electrically conductive layer side.

As for the structure illustrated in Fig. 4, the photosensitive layer 20 is disposed on the substrate 50 having the electrically conductive layer 10 through the undercoating layer 60, the charge transfer layer 30 and the transparent counter electrically conductive layer 40a are disposed thereon, and further the transparent substrate 50a locally having the metal lead 11 is placed on the counter electrically conductive layer 40a so that the metal lead 11 side orients inward. This structure allows light incidence from the counter electrode side.

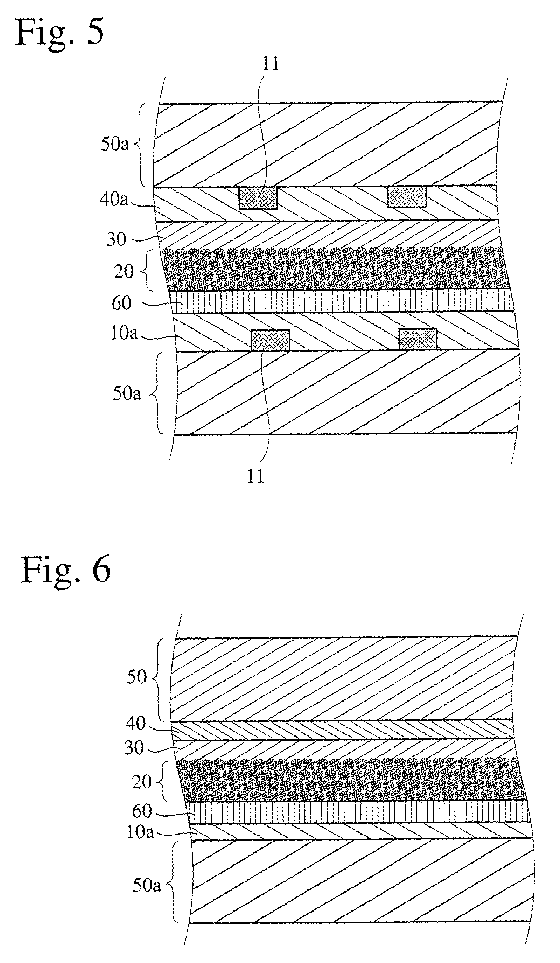

As for the structure illustrated in Fig. 5, on the two transparent substrates 50a each having the metal lead 11 partially are formed the transparent electrically conductive layer 10a and the transparent counter electrically conductive layer 40a, respectively, and the undercoating layer 60, the photosensitive layer 20 and the charge transfer layer 30 placed between the conductive layers. This structure allows light incidence from both faces of the photoelectric conversion device.

As for the structure illustrated in Fig. 6, on the transparent substrate 50a having the transparent electrically conductive layer 10a is disposed the photosensitive layer 20 through the undercoating layer 60, the charge transfer layer 30 and the counter electrically conductive layer 40 are formed thereon, and further the substrate 50 is placed on the counter electrically conductive layer 40. This structure allows light incidence from the electrically conductive layer side.

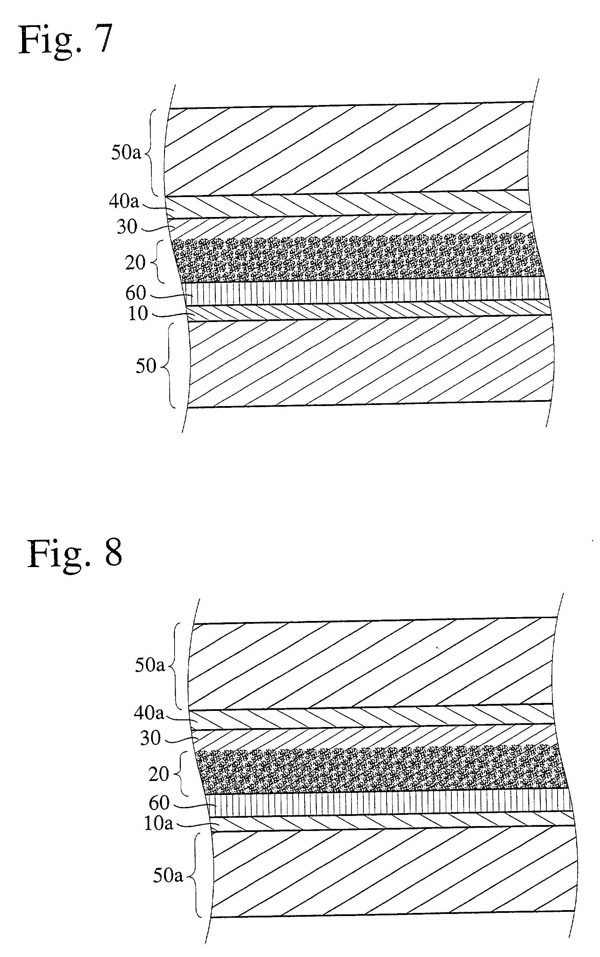

As for the structure illustrated in Fig. 7, on the substrate 50 having the electrically conductive layer 10 is disposed the photosensitive layer 20 through the undercoating layer 60, the charge transfer layer 30 and the transparent counter electrically conductive layer 40a are formed thereon, and further the transparent substrate 50a is placed on the layer 40a. This structure allows light incidence from the counter electrode side.

As for the structure illustrated in Fig. 8, on the transparent substrate 50a having the transparent electrically conductive layer 10a is disposed the photosensitive layer 20 through the undercoating layer 60, the charge transfer layer 30 and the transparent counter electrically conductive layer 40a are formed thereon, and further the transparent substrate 50a is placed on the layer 40a. This structure allows light incidence from both faces of the photoelectric conversion device.

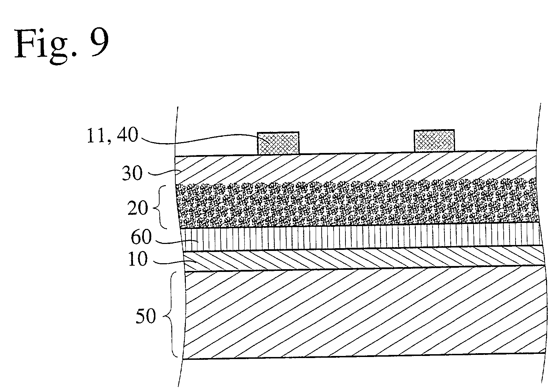

As for the structure illustrated in Fig. 9, the photosensitive layer 20 is disposed on the substrate 50 having the electrically conductive layer 10 through the undercoating layer 60, the solid charge transfer layer 30 is disposed thereon, and further the counter electrically conductive layer 40 or the metal lead 11 is locally placed on the solid charge transfer layer 30. This structure allows light incidence from the counter electrode side.

### [2] Photoelectric Cell

The photoelectric cell of the present invention is constituted by connecting the photoelectric conversion device of the present invention to an external circuit to electrically work or generate electricity in the external circuit. Such a photoelectric cell that has the charge transfer layer composed of ion conductive electrolyte composition is referred to as a photo-electrochemical cell. A photoelectric cell intended for power generation using solar light is referred to as a solar cell.

The side face of the photoelectric cell is preferably sealed with a polymer or an adhesive agent, etc. to prevent deterioration and volatility of the content in the cell. The external circuit is connected to the conductive support and the counter electrode via a lead. Various known circuits may be used in the present invention.

In the case where the photoelectric conversion device of the present invention is applied to the solar cell, the interior structure of the solar cell may be essentially the same as that of the photoelectric conversion device mentioned above. The solar cell comprising the photoelectric conversion device of the present invention may have a known module structure. In general module structure of the solar cell, cells are placed on a substrate of metal, ceramic, etc. and covered with a packing resin, a protective glass, etc., whereby light is introduced from the opposite side of the substrate. The solar cell module may have a structure where the cells are placed on a substrate of a transparent material such as a tempered glass to introduce light from the transparent substrate side. Specifically, a superstraight type module structure, a substrate type module structure, a potting type module structure, substrate-integrated type module structure that is generally used in amorphous silicon solar cells, etc. are known as the solar cell module structure. The solar cell comprising the photoelectric conversion device of the present invention may have a module structure properly selected from the above structures in accordance with ends and environment at use, and preferably has a module structure disclosed in Japanese Patent Laid-Open No. 11-8457.

### EXAMPLES

The present invention will be explained in more detail with reference to examples below without intention of restricting the scope of the present invention.

### 1. Preparation of Coating Dispersion Containing Titanium Dioxide

A titanium dioxide dispersion was prepared in the same manner as a method disclosed in C. J. Barbe, et al, J. Am. Ceramic Soc., 80, 3157 except that the autoclave temperature was 230 °C. The weight ratio of titanium dioxide fine particles was 11 weight % and the average diameter thereof was approximately 10 nm in the titanium dioxide dispersion. Then, 20 weight % of polyethylene glycol (average molecular weight: 20000, Wako Pure Chemical Industries, Ltd.) was added to 100 weight % of the titanium dioxide dispersion, and mixed to prepare a coating dispersion containing titanium dioxide.

### 2. Preparation of Dye-Adsorbed Titanium Dioxide Electrode

The above coating dispersion was applied onto an electrically conductive surface of a transparent conductive support into a thickness of 130 µm by a doctor blade, dried at 25 °C for 30 minutes, and baked by an electric furnace "muffle furnace FP-32" manufactured by Yamato Science K.K. at 550 °C for 30 minutes to provide a titanium dioxide electrode having a titanium dioxide layer. Used as the transparent conductive support was a conductive glass manufactured by Nippon Sheet Glass Co., Ltd. having a surface resistance of approximately 10 Ω/cm², which was composed of a glass substrate and an electrically conductive layer of fluorine-doped tin oxide. Amount of the titanium dioxide in the resultant titanium dioxide layer was 19 g/m², and thickness of the titanium dioxide layer was 13 µm.

Thus-obtained titanium dioxide electrode was cooled, and soaked in a dye adsorption solution *E-1* composed of a dye (A) shown below and a mixture solvent of ethanol/*t*-butanol/acetonitrile = 1/1/2 at an adsorbing temperature of 45 °C for an adsorbing period of 10 hours, to adsorb the dye (A) on the titanium dioxide electrode. Concentration of the dye (A) in the dye adsorption solution *E-1* was 3 × 10⁻³ mol/l. Then, the resultant electrode was washed with each of ethanol and acetonitrile in this order, soaked in a treatment solution composed of the quaternary salt (12) and acetonitrile at a treatment temperature of 40 °C for a treatment period of 2 hours, washed with each of ethanol and acetonitrile in this order, and dried in the dark under nitrogen gas stream, to prepare a dye-adsorbed titanium dioxide electrode. Concentration of the quaternary salt (12) in the treatment solution was 0.01 mol/l.

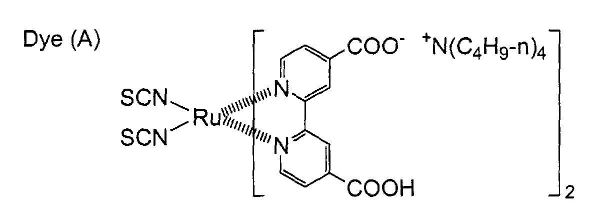

### 3. Production of Photoelectric Cell

The 2 cm x 2 cm in size of the dye-adsorbed titanium dioxide electrode was put on a platinum-deposited glass having the same size thereas. Then, an electrolyte composition composed of 1,3-dimethylimidazolium iodide (0.65 mol/l), iodine (0.05 mol/l), *t*-butylpyridine (0.1 mol/l) and acetonitrile was permeated into a crevice between the dye-adsorbed titanium dioxide electrode and the platinum-deposited glass through capillarity, to produce a photoelectric cell of Example 1.

Photoelectric cells of Examples 2 to 7 were produced in the same manner as the photoelectric cell of Example 1 except that quaternary salts shown in Table 2 were used for the treatment solution instead of the quaternary salt (12), respectively. Incidentally, in the photoelectric cell of Example 7, 5 volume % of *t*-butylpyridine was added to the treatment solution. Further, a photoelectric cell of Comparative Example 1 was produced in the same manner as the photoelectric cell of Example 1 except for not using the quaternary salt (12).

Furthermore, photoelectric cells of Examples 8 to 17 and Comparative Examples 2 to 4 were produced in the same manner as the photoelectric cell of Example 1 except for: that the coating dispersion was applied onto the electrically conductive surface into a thickness of 120 µm and baked at 450 °C after drying, and amount of the titanium dioxide in the titanium dioxide layer was 18 g/m², and thickness of the titanium dioxide layer was 12 µm; that dye adsorption solutions *E-2* to *E-4* shown in Table 1 were used instead of the dye adsorption solution *E-1*, the adsorbing temperature was 25 °C and the adsorbing period was 16 hours; that treatment solutions shown in Table 2 were used instead of the treatment solution composed of the quaternary salt (12), the treatment temperature was 25 °C and the treatment period was 16 hours; and *t*-butylpyridine was not used for the electrolyte composition, respectively.

**Table 1**

| Dye Adsorption Solution | Composition | | | Adsorbing Temperature (°C) | Adsorbing Period (hr) |
|---|---|---|---|---|---|
| | Dye | Solvent (Volume Ratio of Ethanol/*t*-Butanol/Acetonitrile) | Concentration of Dye (mol/l) | | |
| E-1 | (A) | 1/1/2 | 3 × 10⁻³ | 45 | 10 |
| E-2 | R-1 | 1/0/1 | 3 × 10⁻⁴ | 25 | 16 |
| E-3 | M-5 | 1/0/1 | 1 × 10⁴ | 25 | 16 |
| E-4 | M-4 | 1/0/1 | 1 × 10⁻⁴ | 25 | 16 |

### 4. Measurement of Photoelectric Conversion Efficiency

A silver paste was applied to edge portion of the transparent conductive support of each photoelectric cells of Examples 1 to 17 and Comparative Examples 1 to 4, to form a negative electrode. Then, the negative electrode and the platinum-deposited glass were connected to the current-voltage tester "Keithley SMU238". Each of the resultant photoelectric cells was measured with respect to current-voltage properties while perpendicularly irradiating a simulated sunlight thereto, to obtain the photoelectric conversion efficiency. The results were shown in Table 2. Herein, the simulated sunlight was generated by passing the light of 500 W xenone lamp manufactured by Ushio K.K. through "AM 1.5 filter" manufactured by Oriel Co, and had intensity of 100 mW/cm².

**Table 2**

| Ex. No. | Dye Adsorption Solution | Treatment Solution | | | Treatment Temperature (°C) | Treatment Period (hr) | Photoelectric Conversion Efficiency (%) |
|---|---|---|---|---|---|---|---|
| | | Quaternary Salt | Solvent | Concentration of Quaternary Salt (mol/l) | | | |
| Ex. 1 | E-1 | (12) | Acetonitrile | 0.01 | 40 | 2 | 5.7 |
| Ex. 2 | E-1 | (13) | Acetonitrile | 0.01 | 40 | 2 | 6.5 |
| Ex. 3 | E-1 | (14) | Acetonitrile | 0.01 | 40 | 2 | 7.2 |
| Ex. 4 | E-1 | (15) | Acetonitrile | 0.01 | 40 | 2 | 7.5 |
| Ex. 5 | E-1 | (16) | Acetonitrile | 0.01 | 40 | 2 | 7.3 |
| Ex. 6 | E-1 | (17) | Acetonitrile | 0.01 | 40 | 2 | 5.8 |
| Ex. 7 | E-1 | (15) | Acetonitrile | 0.01 | 40 | 2 | 7.7 |
| Comp. Ex. 1 | E-1 | None | Acetonitrile | ― | 40 | 2 | 4.9 |
| Ex.8 | E-2 | (28) | Acetonitrile | 0.04 | 25 | 16 | 6.7 |
| Ex. 9 | E-2 | (27) | Acetonitrile | 0.04 | 25 | 16 | 6.0 |
| Ex. 10 | E-2 | (29) | Acetonitrile | 0.04 | 25 | 16 | 6.5 |
| Ex. 11 | E-2 | (34) | Acetonitrile | 0.04 | 25 | 16 | 7.1 |
| Ex. 12 | E-2 | (35) | Acetonitrile | 0.04 | 25 | 16 | 7.0 |
| Ex. 13 | E-2 | (38) | Acetonitrile | 0.04 | 25 | 16 | 6.9 |
| Ex. 14 | E-2 | (39) | Acetonitrile | 0.04 | 25 | 16 | 5.9 |
| Ex. 15 | E-2 | (46) | Acetonitrile | 0.04 | 25 | 16 | 7.2 |
| Comp. Ex. 2 | E-2 | None | Acetonitrile | ― | 25 | 16 | 5.5 |
| Ex. 16 | E-3 | (28) | Acetonitrile | 0.04 | 25 | 16 | 4.4 |
| Comp. Ex. 3 | E-3 | None | Acetonitrile | ― | 25 | 16 | 3.8 |
| Ex. 17 | E-4 | (28) | Acetonitrile | 0.04 | 25 | 16 | 4.2 |
| Comp. Ex. 4 | E-4 | None | Acetonitrile | ― | 25 | 16 | 3.5 |

Comparing Examples 1 to 7 with Comparative Example 1, Examples 8 to 15 with Comparative Example 2, Example 16 with Comparative Example 3, and Example 17 with Comparative Example 4, the photoelectric cells of the present invention using the dye treated with the quaternary salt exhibited high photoelectric conversion efficiency not depending on the kind of the dye.

As compared with the photoelectric cells of Examples 1 and 6, the photoelectric cell of Example 2 exhibited higher photoelectric conversion efficiency. It was clear from this that the tetralkylammonium salt was preferably used as the quaternary salt. Further, the photoelectric cells of Examples 3 to 5 exhibited the photoelectric conversion efficiency higher than that of the photoelectric cell of Example 2, accordingly, it was preferred that the tetralkylammonium salt has an alkyl group containing 6 or more carbon atoms such as a hexyl group.

Among Examples 1 to 17, the photoelectric cell of Example 7 exhibited the most excellent photoelectric conversion efficiency. This seemed because the preferred quaternary salt was used in combination with a pyridine compound.

As described in detail above, a photoelectric conversion device of the present invention is excellent in photoelectric conversion efficiency. Thus, a photoelectric cell of the present invention using this photoelectric conversion device is remarkably usable as a solar cell.

## Claims

1. A photoelectric conversion device comprising: a conductive support; a photosensitive layer containing a semiconductor fine particle on which a dye is adsorbed; a charge transfer layer; and a counter electrode, wherein said dye is treated with a treatment solution composed of a quaternary salt and a solvent before or after said dye is adsorbed on said semiconductor fine particle.

2. The photoelectric conversion device according to claim 1, wherein said quaternary salt is selected from the group consisting of tetralkylammonium salts, imidazolium salts and pyridinium salts.

3. The photoelectric conversion device according to claim 1 or 2, wherein said quaternary salt has a pyridyl group.

4. The photoelectric conversion device according to claim 3, wherein said quaternary salt is represented by the following general formula (I): 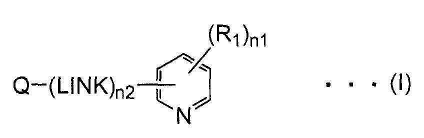 wherein *Q* represents a quaternary ammonium salt moiety, *LINK* represents a divalent linking group, *R*_{*1*} represents a substituent, *n1* represents an integer of 0 to 4, and *n2* represents 0 or 1.

5. The photoelectric conversion device according to claim 4, wherein said *Q* is a tetralkylammonium salt moiety.

6. The photoelectric conversion device according to any one of claims 1 to 5, wherein said quaternary salt has at least one alkyl group containing 6 or more carbon atoms.

7. The photoelectric conversion device according to any one of claims 1 to 6, wherein said solvent is a nitrile compound.

8. The photoelectric conversion device according to any one of claims 1 to 7, wherein said dye has an acidic group.

9. The photoelectric conversion device according to claim 8, wherein the molecularity of said quaternary salt in said treatment solution is equivalent to or more than the total number of said acidic group of said dye in said photosensitive layer.

10. The photoelectric conversion device according to any one of claims 1 to 9, wherein a ruthenium complex dye and/or a methine dye is used as said dye.

11. A photoelectric cell composed of the photoelectric conversion device recited in any one of claims 1 to 10.
